# EUROPEAN PATENT APPLICATION

(11) **EP 4 510 166 A1**
(43) Date of publication of application: **19.02.2025**
(21) Application number: 23802717.1
(22) Date of filing: 28.04.2023
(51) Int. Cl.: H01J 23/34

(54) **TRAVELING WAVE TUBE, ELECTRON GUN, AND POWER AMPLIFICATION SYSTEM**

(30) Priority: 13.05.2022 CN 202210521819
(71) Applicant: Huawei Technologies Co., Ltd., Shenzhen, Guangdong 518129 (CN)
(72) Inventor: CHENG, Qianfu, Shenzhen, Guangdong 518129 (CN); WANG, Xin, Shenzhen, Guangdong 518129 (CN)
(74) Representative: Gill Jennings & Every LLP
(86) International application number: PCT/CN2023/091846
(87) International publication number: WO 2023/216945

(57) **Abstract**

This application provides a travelling-wave tube, an electron gun, and a power amplification system, to improve electronic efficiency of the travelling-wave tube when the travelling-wave tube performs linear amplification on a radio frequency signal, thereby effectively reducing power consumption of the travelling-wave tube. The travelling-wave tube includes an input apparatus, a control circuit, an electron gun, a slow-wave circuit, and an output apparatus. The input apparatus may be configured to: receive a radio frequency signal, and feed the radio frequency signal into the slow-wave circuit. The control circuit may be configured to: determine a quantity N of electron beams and currents of the N electron beams, and control the electron gun to emit the N electron beams. Further, the slow-wave circuit may perform beam-wave interaction with the N electron beams, to amplify power of the radio frequency signa, and because the slow-wave circuit works in a saturation region, electronic efficiency of the travelling-wave tube can be greater than or equal to a first threshold. The output apparatus may output an amplified radio frequency signal.

## Description

### CROSS-REFERENCE TO RELATED APPLICATIONS

This application claims priority to Chinese Patent Application No. 202210521819.7, filed with the China National Intellectual Property Administration on May 13, 2022 and entitled "TRAVELLING-WAVE TUBE, ELECTRON GUN, AND POWER AMPLIFICATION SYSTEM", which is incorporated herein by reference in its entirety.

### TECHNICAL FIELD

Embodiments of this application relate to the field of communication technologies, and in particular, to a travelling-wave tube, an electron gun, and a power amplification system.

### BACKGROUND

To meet an ultra-large-capacity transmission requirement of a communication system, an operating frequency band of the communication system has been extended to a high frequency band (for example, 40 GHz) in the 3^{rd} generation partnership project (3^{rd} generation partnership project, 3GPP) standard. However, a high transmission path loss and a high penetration loss exist in a high-frequency communication system, and consequently, application scenarios of the high-frequency communication system are limited. A millimeter-wave transmitter is characterized by a wide frequency band and high linearity, and is applicable to the high-frequency communication system. Therefore, research on a high-power millimeter-wave transmitter is of great significance to expanding the application scenarios of the high-frequency communication system. A millimeter-wave power amplifier is an indispensable module in the millimeter-wave transmitter, and its performance directly determines performance of the millimeter-wave transmitter. Therefore, development of a high-performance millimeter-wave power amplifier is the key to the high-power millimeter-wave transmitter.

Currently, common millimeter-wave power amplifiers include a solid state power amplifier (solid state power amplifier, SSPA) and a travelling-wave tube amplifier (travelling-wave tube amplifier, TWTA). Generally, the travelling-wave tube amplifier is briefly referred to as a travelling-wave tube. The SSPA is applicable to a communication scenario with a low power requirement, and the TWTA is applicable to a communication scenario with a high power requirement. Therefore, the TWTA is usually used in a high-power transmitter.

To achieve an ultra-high-speed system rate and high frequency utilization, the high-frequency communication system usually uses an orthogonal frequency division multiplexing (orthogonal frequency division multiplexing, OFDM) signal with a high wideband (for example, with a bandwidth of 400 MHz/800 MHz) and high-order modulation (for example, 16QAM/64QAM/256QAM), and this type of signal has very high peak power (also referred to as saturation power).

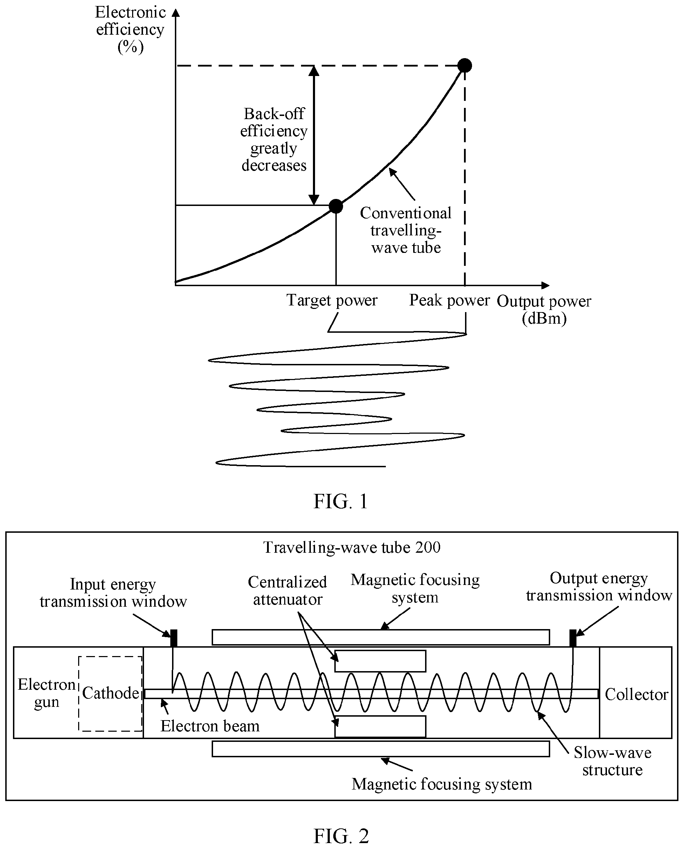

As shown in FIG. 1, when performing linear amplification on this type of signal, the TWTA needs to work in a linear amplification region. However, when the TWTA works in the linear amplification region, as output power of the TWTA decreases, electronic efficiency (that is, efficiency of converting electric energy into radio frequency energy) of the TWTA greatly decreases, and it is difficult to meet a power consumption requirement of the high-frequency communication system.

Therefore, when the TWTA works in the linear amplification region, how to improve the electronic efficiency of the TWTA to reduce power consumption of the TWTA is a problem that urgently needs to be resolved in the art.

### SUMMARY

Embodiments of this application provide a travelling-wave tube, an electron gun, and a power amplification system, to improve electronic efficiency of the travelling-wave tube when the travelling-wave tube performs linear amplification on a radio frequency signal, and therefore effectively reduce power consumption of the travelling-wave tube.

According to a first aspect, an embodiment of this application provides a travelling-wave tube. The travelling-wave tube includes an input apparatus, a control circuit, an electron gun, a slow-wave circuit, and an output apparatus. The input apparatus may be configured to: receive a radio frequency signal, and feed the radio frequency signal into the slow-wave circuit. The control circuit may be configured to determine a quantity N of electron beams and currents of the N electron beams. Electronic efficiency of the travelling-wave tube is greater than or equal to a first threshold, and N is a positive integer greater than or equal to 1. The electron gun may be configured to emit the N electron beams under control of the control circuit. The slow-wave circuit may be configured to perform beam-wave interaction with the N electron beams, to amplify power of the radio frequency signal. The output apparatus may be configured to output an amplified radio frequency signal.

In this embodiment of this application, the control circuit is added to the travelling-wave tube. The control circuit may determine the quantity N of electron beams emitted by the electron gun in the travelling-wave tube and the currents of the N electron beams, and control the electron gun in the travelling-wave tube to emit the N electron beams. Further, the slow-wave circuit may perform beam-wave interaction with the N electron beams, so that input power and output power of the radio frequency signal are linearly correlated, and the power of the radio frequency signal is linearly amplified. In addition, the slow-wave circuit works in a saturation region, so that electronic efficiency of the travelling-wave tube can be greater than or equal to the first threshold. In this way, linear amplification is performed on the radio frequency signal while the electronic efficiency of the travelling-wave tube is effectively improved and power consumption of the travelling-wave tube is further effectively reduced, so that a low power consumption requirement of a high-frequency communication system can be met.

In a possible design, the slow-wave circuit may include a power divider, M slow-wave structures, and M switches. The M slow-wave structures are in one-to-one correspondence with the M switches, and M is greater than or equal to N. The control circuit may be further configured to: control the power divider to decompose the radio frequency signal fed into the slow-wave circuit into N sub-signals; and turn on N switches in the M switches, and input the N sub-signals to N slow-wave structures in the M slow-wave structures, where the N switches are in one-to-one correspondence with the N slow-wave structures, and one of the N sub-signals is input to one of the N slow-wave structures.

In this design, the control circuit may control the power divider to decompose the radio frequency signal fed into the slow-wave circuit into the N sub-signals, turn on the N switches in the M switches, input the N sub-signals to the N slow-wave structures in the M slow-wave structures, and control each of the N slow-wave structures to work in the saturation region. In this way, one of the N sub-signals may be input to one of the N slow-wave structures, then the one slow-wave structure may amplify power of the one sub-signal, the slow-wave structure can work in the saturation region, and electronic efficiency of the slow-wave structure is effectively improved.

Correspondingly, that the slow-wave circuit performs beam-wave interaction with the N electron beams, to amplify the power of the radio frequency signal includes: The N electron beams passing through the N slow-wave structures performs beam-wave interaction with the N slow-wave structures, to amplify power of the N sub-signals, where one of the N electron beams performs beam-wave interaction with one of the N slow-wave structures through which the electron beam passes, to amplify power of one sub-signal input to the one slow-wave structure. In this way, the electron beam passing through the slow-wave structure performs beam-wave interaction with the slow-wave structure, to amplify the power of the sub-signal input to the slow-wave structure.

In a possible design, the slow-wave circuit further includes a power combiner. The control circuit may be further configured to control the power combiner to combine amplified N sub-signals into the amplified radio frequency signal.

In this design, the N amplified sub-signals are combined by using the power combiner and output, so that the travelling-wave tube can completely output the amplified radio frequency signal.

That the control circuit is configured to determine a quantity N of electron beams and currents of the N electron beams includes but is not limited to the following implementations.

Implementation 1: The control circuit receives a control signal, where the control signal indicates a value of N and the currents of the N electron beams.

In this implementation, the control circuit may directly determine the quantity N of electron beams and the currents of the N electron beams based on the received control signal, and implementation of the control circuit is simple.

Implementation 2: The control circuit determines a value of N and the currents of the N electron beams based on the input power of the radio frequency signal.

In this implementation, the control circuit may determine the quantity N of the electron beams and the currents of the N electron beams based on the input power of the radio frequency signal, and does not need to receive the control signal, to effectively improve efficiency of determining the quantity N of electron beams and the currents of the N electron beams by the control circuit.

In a possible design, that the control circuit determines the value of N and the currents of the N electron beams based on the input power of the radio frequency signal includes: if the input power of the radio frequency signal is less than or equal to a second threshold, determining that the value of N is 1, and determining the currents of the N electron beams; or if the input power of the radio frequency signal is greater than a second threshold, determining that the value of N is greater than 1, and determining the currents of the N electron beams, where a current of at least one of the N electron beams reaches a current threshold of the at least one electron beam, and the value of N is positively correlated with the input power of the radio frequency signal.

In this design, the control circuit determines the value of N and the currents of the N electron beams with reference to the input power of the radio frequency signal, so that output power and input power of the radio frequency signal amplified by the travelling-wave tube are linearly correlated, and in addition, the N slow-wave structures that are in the slow-wave circuits and that correspond to the N electron beams can work in the saturation state, to effectively improve electronic efficiency of the N slow-wave structures, and further effectively improve the electronic efficiency of the travelling-wave tube.

In a possible design, the electron gun includes M cathodes, where M is greater than or equal to N. Correspondingly, that the control circuit controls the electron gun to emit the N electron beams includes: adjusting currents of the M cathodes based on the value of N and the currents of the N electron beams, and controlling N cathodes in the M cathodes to emit the N electron beams, where each of the N cathodes is configured to emit one of the N electron beams, a current of each of the N cathodes is related to a current of an electron beam emitted by the cathode, and the current of each of the N cathodes is greater than 0.

It should be noted that "a current of each of the N cathodes is related to a current of an electron beam emitted by the cathode" may be understood as that a current of each of the N cathodes is equal to a current of an electron beam emitted by the cathode.

In this design, after determining the quantity N of electron beams emitted by the electron gun and the currents of the N electron beams, the control circuit may adjust the currents of the M cathodes based on the quantity N of the electron beams and the currents of the N electron beams, so that currents of the N cathodes in the M cathodes are greater than 0, and then the N cathodes may emit the N electron beams.

In a possible design, the electron gun further includes H anodes, where each of the M cathodes corresponds to at least one of the H anodes, the at least one anode is connected to the control circuit, and H is greater than or equal to M. That the control circuit adjusts the currents of the M cathodes includes: adjusting a voltage of the at least one anode. In this design, the control circuit adjusts the currents of the M cathodes by adjusting voltages of the anodes associated with the M cathodes.

In a possible design, the electron gun further includes M gates, where the M gates are connected to the control circuit, and the M cathodes are in one-to-one correspondence with the M gates. That the control circuit adjusts the currents of the M cathodes includes: adjusting voltages of the M gates. In this design, the control circuit adjusts the currents of the M cathodes by adjusting the voltages of the gates associated with the M cathodes.

In a possible design, the electron gun further includes M focusing electrodes, where the M focusing electrodes are connected to the control circuit, and the M cathodes are in one-to-one correspondence with the M focusing electrodes. That the control circuit adjusts the currents of the M cathodes includes: adjusting voltages of the M focusing electrodes. In this design, the control circuit adjusts the currents of the M cathodes by adjusting the voltages of the focusing electrodes associated with the M cathodes.

In a possible design, the travelling-wave tube further includes a magnetic focusing system. The magnetic focusing system may be configured to focus the N electron beams, to enable the N electron beams to remain in a focused state. In this design, the magnetic focusing system focuses the N electron beams, to enable the N electron beams to remain in the focused state, so that the N electron beams can smoothly pass through the slow-wave circuit.

In a possible design, the travelling-wave tube further includes an absorption set, where the absorption set may be configured to recover remaining energy of the N electron beams, to further reduce the power consumption of the travelling-wave tube.

According to a second aspect, an embodiment of this application further provides an electron gun. The electron gun includes M cathodes and a control circuit. The control circuit may be configured to determine a quantity N of electron beams and currents of the N electron beams. Electronic efficiency of a travelling-wave tube is greater than or equal to a first threshold, N is a positive integer greater than or equal to 1, and M is greater than or equal to N. N cathodes in the M cathodes may be configured to emit the N electron beams under control of the control circuit, where each of the N cathodes is configured to emit one of the N electron beams.

In this embodiment of this application, the control circuit is added to the electron gun. The control circuit may control the quantity and the currents of the electron beams emitted by the electron gun. Further, when the electron beams emitted by the electron gun are used to amplify a radio frequency signal of the travelling-wave tube, electronic efficiency of the travelling-wave tube is greater than or equal to a first threshold, to meet a low power consumption requirement of the travelling-wave tube.

In a possible design, that the control circuit is configured to determine the quantity N of electron beams and the currents of the N electron beams includes: receiving a control signal, where the control signal indicates a value of N and the currents of the N electron beams; or determining a value of N and the currents of the N electron beams based on input power of a to-be-amplified radio frequency signal in the travelling-wave tube.

In a possible design, that the control circuit is configured to determine the value of N and the currents of the N electron beams based on the input power of the radio frequency signal includes: if the input power of the radio frequency signal is less than or equal to a second threshold, determining that the value of N is 1, and determining the currents of the N electron beams; or if the input power of the radio frequency signal is greater than a second threshold, determining that the value of N is greater than 1, and determining the currents of the N electron beams, where a current of at least one of the N electron beams reaches a current threshold of the at least one electron beam, and the value of N is positively correlated with the input power of the radio frequency signal.

In a possible design, that the control circuit controls the N cathodes in the M cathodes to emit the N electron beams includes: adjusting currents of the M cathodes based on the value of N and the currents of the N electron beams, to control a current of each of the N cathodes to be greater than 0, where the current of each of the N cathodes is related to a current of an electron beam emitted by the cathode.

In a possible design, the electron gun further includes H anodes, where each of the M cathodes corresponds to at least one of the H anodes, the at least one anode is connected to the control circuit, and H is greater than or equal to M. That the control circuit adjusts the currents of the M cathodes includes: adjusting a voltage of the at least one anode.

In a possible design, the electron gun further includes M gates, where the M gates are connected to the control circuit, and the M cathodes are in one-to-one correspondence with the M gates. That the control circuit adjusts the currents of the M cathodes includes: adjusting voltages of the M gates.

In a possible design, the electron gun further includes M focusing electrodes, where the M focusing electrodes are connected to the control circuit, and the M cathodes are in one-to-one correspondence with the M focusing electrodes. That the control circuit adjusts the currents of the M cathodes includes: adjusting voltages of the M focusing electrodes.

According to a third aspect, an embodiment of this application further provides a power amplification system, including a first signal processing unit and the travelling-wave tube according to any one of the first aspect and the possible designs of the first aspect. The first signal processing unit is connected to the travelling-wave tube; the first signal processing unit is configured to input a radio frequency signal to the travelling-wave tube; and the travelling-wave tube is configured to amplify power of the radio frequency signal.

In a possible design, a second signal processing unit is further included. The second signal processing unit is configured to: generate a control signal, and input the control signal to the travelling-wave tube, where the control signal indicates a quantity of electron beams emitted by an electron gun in the travelling-wave tube and currents of the N electron beams.

For beneficial effects of the technical solution according to any possible design in the second aspect and beneficial effects of the technical solution according to the third aspect and the possible designs in the third aspect, refer to related descriptions in the first aspect. Details are not described herein again.

### BRIEF DESCRIPTION OF DRAWINGS

FIG. 1 is a diagram of a relationship between output power and electronic efficiency of a travelling-wave tube;
FIG. 2 is a diagram of a structure of a travelling-wave tube;
FIG. 3 is a diagram of a structure of another travelling-wave tube;
FIG. 4 is a diagram of a structure of another travelling-wave tube;
FIG. 5 shows a power amplification system according to an embodiment of this application;
FIG. 6 is a diagram of a structure of a travelling-wave tube according to an embodiment of this application;
FIG. 7 is a diagram of a structure of an electron gun according to an embodiment of this application;
FIG. 8 is a diagram of a structure of another electron gun according to an embodiment of this application;
FIG. 9 is a diagram of a structure of another electron gun according to an embodiment of this application;
FIG. 10 is a diagram of a structure of another electron gun according to an embodiment of this application;
FIG. 11 is a diagram of a structure of a slow-wave circuit according to an embodiment of this application;
FIG. 12 is a diagram of a mapping relationship between a current of an electron beam and a digital bit in a control signal according to an embodiment of this application;
FIG. 13 is a diagram of a relationship between input power and output power of a sub-signal in a slow-wave structure according to an embodiment of this application; and
FIG. 14 is a diagram of a relationship between electronic efficiency and output power of a travelling-wave tube according to an embodiment of this application.

### DESCRIPTION OF EMBODIMENTS

The following describes embodiments of this application in detail with reference to the accompanying drawings.

The following explains some terms in this application. It should be noted that these explanations are intended for ease of understanding by a person skilled in the art, but are not intended to limit the protection scope claimed in this application.
(1) An electron beam is an electron beam formed by electrons emitted by an electron gun in a focused state, which is referred to herein as the electron beam.
(2) Electronic efficiency is efficiency of converting electric energy into radio frequency energy by a travelling-wave tube. In a possible implementation, the electronic efficiency of the travelling-wave tube=output power of a radio frequency signal/(a voltage of the electron beam*a current of the electron beam).

In embodiments of this application, the travelling-wave tube includes a slow-wave circuit, the slow-wave circuit includes a plurality of slow-wave structures, and electronic efficiency of each slow-wave structure is related to input power of a radio frequency signal input to the slow-wave structure.

For example, a radio frequency signal 1 is input to a slow-wave structure 1, and an electron beam 1 passes through the slow-wave structure 1. If input power of the radio frequency signal 1 is less than saturation input power of the slow-wave structure 1 (that is, radio frequency input power corresponding to the slow-wave structure 1 working at a saturation point), electronic efficiency of the slow-wave structure 1=(the input power of the radio frequency signal 1 *an amplification multiple)/(a voltage of the electron beam 1 *a current of the electron beam 1).

For another example, a radio frequency signal 1 is input to a slow-wave structure 1, an electron beam 1 passes through the slow-wave structure 1, a radio frequency signal 2 is input to a slow-wave structure 2, and an electron beam 2 passes through the slow-wave structure 2. If input power of the radio frequency signal 1 is greater than or equal to saturation input power of the slow-wave structure 1 (that is, input power corresponding to the slow-wave structure 1 working at a saturation point), and input power of the radio frequency signal 2 is less than saturation input power of the slow-wave structure 2 (that is, input power corresponding to the slow-wave structure 2 working at a saturation point), electronic efficiency of the slow-wave structure 1 is preset target electronic efficiency, and electronic efficiency of the slow-wave structure 2=(total output power of the travelling-wave tube-the saturation output power of the slow-wave structure 1)/(a voltage of the electron beam 2*(a current of the electron beam 1+a current of the electron beam 2)).

For another example, a radio frequency signal 1 is input to a slow-wave structure 1, and an electron beam 1 passes through the slow-wave structure 1; a radio frequency signal 2 is input to a slow-wave structure 2, and an electron beam 2 passes through the slow-wave structure 2; and a radio frequency signal 3 is input to a slow-wave structure 3, and an electron beam 3 passes through the slow-wave structure 3. If input power of the radio frequency signal 1 is greater than or equal to saturation input power of the slow-wave structure 1, input power of the radio frequency signal 2 is greater than or equal to saturation input power of the slow-wave structure 2, and input power of the radio frequency signal 3 is less than saturation input power of the slow-wave structure 3, electronic efficiency of the slow-wave structure 1 and electronic efficiency of the slow-wave structure 2 are both preset target electronic efficiency, and electronic efficiency of the slow-wave structure 3=(total output power of the travelling-wave tube-the saturation output power of the slow-wave structure 1-the saturation output power of the slow-wave structure 2)/(a voltage of the electron beam 3*(a current of the electron beam 1+a current of the electron beam 2+a current of the electron beam 3)).

By analogy, a radio frequency signal 1 is input to a slow-wave structure 1, and an electron beam 1 passes through the slow-wave structure 1; a radio frequency signal 2 is input to a slow-wave structure 2, and an electron beam 2 passes through the slow-wave structure 2; a radio frequency signal 3 is input to a slow-wave structure 3, and an electron beam 3 passes through the slow-wave structure 3; ...; and a radio frequency signal N is input to a slow-wave structure N, and an electron beam N passes through the slow-wave structure N. If input power of the radio frequency signal 1 is greater than or equal to saturation input power of the slow-wave structure 1, input power of the radio frequency signal 2 is greater than or equal to saturation input power of the slow-wave structure 2, input power of the radio frequency signal 3 is greater than or equal to saturation input power of the slow-wave structure 3, ..., and input power of the radio frequency signal N is greater than or equal to saturation input power of the slow-wave structure N, electronic efficiency of the slow-wave structure 1, electronic efficiency of the slow-wave structure 2, electronic efficiency of the slow-wave structure 3, ..., and electronic efficiency of the slow-wave structure N are all preset target electronic efficiency.

(3) A saturation region reflects one of output characteristics of the travelling-wave tube. When the travelling-wave tube works in the saturation region, the electronic efficiency of the travelling-wave tube reaches a peak value.

(4) A linear amplification region reflects one of the output characteristics of the travelling-wave tube. When the travelling-wave tube works in the linear amplification region, the electronic efficiency of the travelling-wave tube is low. The linear amplification region is also referred to as a power back-off region in embodiments of this application. In the technical solution provided in embodiments of this application, the electron gun and the slow-wave circuit in the travelling-wave tube are controlled, so that the slow-wave structure in the slow-wave circuit works in the saturation region, and the electronic efficiency of the slow-wave structure is improved. Further, when the travelling-wave tube works in a back-off state, the electronic efficiency of the travelling-wave tube can still be effectively improved.

(5) A nonlinear amplification region reflects one of the output characteristics of the travelling-wave tube. When the travelling-wave tube works in the nonlinear amplification region, the electronic efficiency of the travelling-wave tube is high, and a gain is reduced in comparison with that in the linear region. Distortion occurs to some extent when the travelling-wave tube works in this region.

In the technical solution provided in embodiments of this application, the electron gun and the slow-wave circuit in the travelling-wave tube are controlled, so that the travelling-wave tube can work in the saturation region, and the travelling-wave tube does not work in the non-linear amplification region. In this way, high electronic efficiency can be obtained while travelling-wave distortion is effectively reduced and linear amplification on the radio frequency signal is implemented.

(6) Back-off efficiency is electronic efficiency (as shown in FIG. 1) reduced when output power of the travelling-wave tube is backed off from peak power to target power, that is, back-off power of the travelling-wave tube switching from the saturation region to the linear amplification region.

(7) "A plurality of" in embodiments of this application means two or more. The term "and/or" describes an association relationship between associated objects and represents that three relationships may exist. For example, A and/or B may represent the following three cases: Only A exists, both A and B exist, and only B exists. The character "/" generally indicates that the associated objects are in an "or" relationship. In addition, it should be understood that although the terms such as "first" and "second" may be used in embodiments of the present invention to describe objects, these objects should not be limited to these terms. These terms are merely used to distinguish objects from each other.

(8) The terms "include" and "have" and any variant thereof mentioned in the descriptions of embodiments of this application are intended to cover a non-exclusive inclusion. For example, a process, a method, a system, a product, or a device that includes a series of steps or units is not limited to the listed steps or units, but optionally further includes other unlisted steps or units, or optionally further includes another inherent step or unit of the process, the method, the product, or the device. It should be noted that, in embodiments of this application, the word such as "example" or "for example" is used to represent giving an example, an illustration, or a description. Any embodiment or design scheme described as an "example" or with "for example" in embodiments of this application should not be explained as being more preferred or having more advantages than another embodiment or design scheme. Exactly, use of the word "example", "for example", or the like is intended to present a related concept in a specific manner.

FIG. 2 is a diagram of a structure of a travelling-wave tube. As shown in FIG. 2, the travelling-wave tube 200 includes an electron gun, a slow-wave circuit, a centralized attenuator, an input energy transmission window, an output energy transmission apparatus, a magnetic focusing system, and a collector. The electron gun includes a cathode, and the cathode may generate an electron beam. The magnetic focusing system may focus the electron beam, to enable the electron beam to remain in a focused state. Then the electron beam may pass through the slow-wave circuit. The input energy transmission window may be configured to feed a to-be-amplified radio frequency signal into the slow-wave circuit, and the to-be-amplified radio frequency signal travels along the slow-wave circuit. The electron beam passing through the slow-wave circuit performs beam-wave interaction with the slow-wave circuit, to amplify power of the to-be-amplified radio frequency signal. The output energy transmission window outputs an amplified radio frequency signal. Further, the collector may be configured to recover remaining energy of the electron beam. The centralized attenuator may be configured to absorb a reflected wave of an electromagnetic wave in the travelling-wave tube, to avoid parasitic oscillation in the travelling-wave tube.

It should be noted that the travelling-wave tube 200 is a pure analog device, and performance of the travelling-wave tube 200 is completely determined by a physical structure and electromagnetic performance of the device. As shown in FIG. 1, to implement linear amplification on a wideband complex modulation signal, the travelling-wave tube 200 needs to work in a power back-off region. However, as output power of a radio frequency signal in the travelling-wave tube 200 decreases, electronic efficiency of the travelling-wave tube 200 greatly decreases. Consequently, electronic efficiency of the travelling-wave tube 200 at a working point is low, and it is difficult to meet a power consumption requirement of a high-frequency communication system.

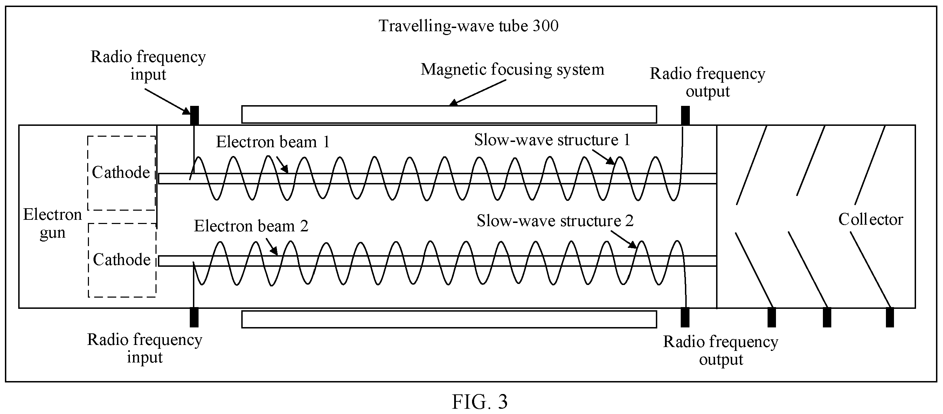

FIG. 3 is a diagram of a structure of another travelling-wave tube. In FIG. 3, an electron gun in the travelling-wave tube 300 includes a plurality of cathodes, and each cathode may emit one electron beam. A slow-wave circuit in the travelling-wave tube 300 includes a plurality of slow-wave structures, one of the plurality of slow-wave structures corresponds to one of the plurality of cathodes, and each slow-wave structure performs beam-wave interaction with one electron beam, to amplify a radio frequency signal in each slow-wave structure. Although for the travelling-wave tube 300, output power of the travelling-wave tube can be increased, each slow-wave structure in the travelling-wave tube 300 needs to work in a power back-off region when amplifying the radio frequency signal. Consequently, the travelling-wave tube 300 still has a problem of low electronic efficiency.

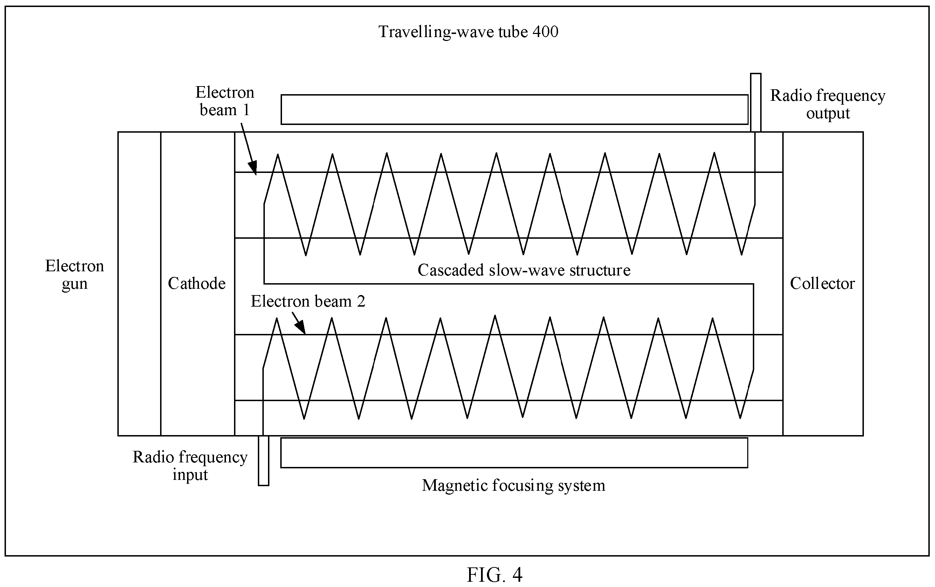

FIG. 4 is a diagram of a structure of another travelling-wave tube. In FIG. 4, an electron gun in the travelling-wave tube 400 includes a plurality of cathodes, and each cathode may emit one electron beam. A slow-wave circuit in the travelling-wave tube 400 includes a plurality of cascaded slow-wave structures, and a plurality of electron beams emitted by the electron gun perform beam-wave interaction with the plurality of cascaded slow-wave structures, to amplify radio frequency signals passing through the plurality of cascaded slow-wave structures. Although for the travelling-wave tube 400, output power of the travelling-wave tube can be increased and a longitudinal length of the travelling-wave tube 400 can be reduced, the plurality of cascaded slow-wave structures need to work in a power back-off region when amplifying the radio frequency signals. Consequently, the travelling-wave tube 400 still has a problem of low electronic efficiency.

In conclusion, when performing linear amplification on the radio frequency signal, the travelling-wave tube needs to work in a linear amplification region (the power back-off region). Consequently, the travelling-wave tube has the problem of low electronic efficiency.

In view of this, embodiments of this application provide a travelling-wave tube, an electron gun, and a power amplification system, to improve electronic efficiency of the travelling-wave tube when the travelling-wave tube performs linear amplification on a radio frequency signal, and therefore effectively reduce power consumption of the travelling-wave tube. The travelling-wave tube includes an input apparatus, a control circuit, an electron gun, a slow-wave circuit, and an output apparatus. The input apparatus may be configured to: receive a radio frequency signal, and feed the radio frequency signal into the slow-wave circuit. The control circuit may be configured to determine a quantity N of electron beams and currents of the N electron beams. Electronic efficiency of the travelling-wave tube is greater than or equal to a first threshold, and N is a positive integer greater than or equal to 1. The electron gun may be configured to emit the N electron beams under control of the control circuit. The slow-wave circuit may be configured to perform beam-wave interaction with the N electron beams, to amplify power of the radio frequency signal. The output apparatus may be configured to output an amplified radio frequency signal.

It should be noted that the travelling-wave tube in embodiments of this application may be used in a terminal, or may be used in a base station.

The travelling-wave tube, the electron gun, and the power amplification system in embodiments of this application may be used in various communication systems, for example, a global system for mobile communication (global system for mobile communication, GSM), a code division multiple access (code division multiple access, CDMA) system, a wideband code division multiple access (wideband code division multiple access, WCDMA) system, a general packet radio service (general packet radio service, GPRS) system, a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, WiMAX) communication system, a 5^{th} generation (5^{th} generation, 5G) system or a new radio (new radio, NR) system, a future 6^{th} generation (6^{th} generation, 6G) system, an inter-satellite communication system, and a satellite communication system. The antenna and/or the antenna system in embodiments of this application may be further used in another communication system. Details are not described herein.

In embodiments of this application, the control circuit is added to the travelling-wave tube. The control circuit may determine the quantity N of electron beams emitted by the electron gun in the travelling-wave tube and the currents of the N electron beams, and control the electron gun in the travelling-wave tube to emit the electron beams. Further, the slow-wave circuit may perform beam-wave interaction with the N electron beams, so that input power and output power of the radio frequency signal are linearly correlated, and the power of the radio frequency signal is linearly amplified. In addition, the slow-wave circuit works in a saturation region, so that the electronic efficiency of the travelling-wave tube can be greater than or equal to the first threshold. In this way, the linear amplification is performed on the radio frequency signal while the electronic efficiency of the travelling-wave tube is effectively improved and the power consumption of the travelling-wave tube is further effectively reduced, so that a low power consumption requirement of a high-frequency communication system can be met.

The following describes in detail the travelling-wave tube, the electron gun, and the power amplification system provided in embodiments of this application with reference to specific accompanying drawings.

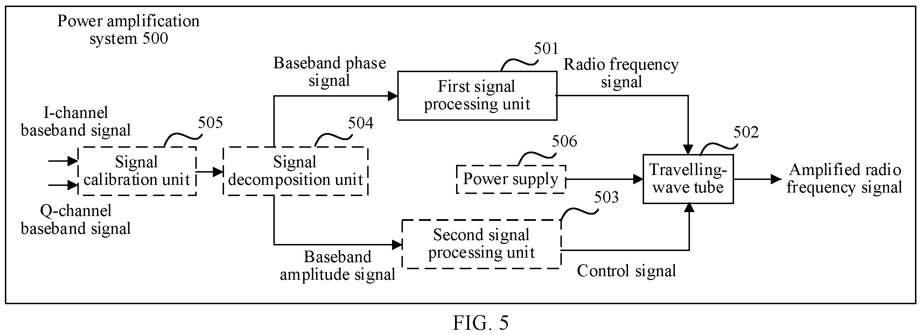

Based on the foregoing content, FIG. 5 is a diagram of a structure of a power amplification system according to an embodiment of this application. In FIG. 5, the power amplification system 500 includes a first signal processing unit 501 and a travelling-wave tube 502. The first signal processing unit 501 is connected to the travelling-wave tube 502. The first signal processing unit 501 may input a radio frequency signal to the travelling-wave tube 502, and then the travelling-wave tube 502 may amplify power of the radio frequency signal.

Optionally, the power amplification system 500 further includes a second signal processing unit 503. The second signal processing unit 503 may generate a control signal, and input the control signal to the travelling-wave tube 502, where the control signal may indicate a quantity of electron beams emitted by an electron gun in the travelling-wave tube 502 and currents of the N electron beams. Further, the travelling-wave tube 502 may control, based on the control signal, the quantity of electron beams emitted by the electron gun in the travelling-wave tube 502 and the currents of the N electron beams, so that the travelling-wave tube 502 implements linear amplification on the radio frequency signal while electronic efficiency of the travelling-wave tube 502 is effectively improved and power consumption of the travelling-wave tube 502 is effectively reduced.

In a possible implementation, the second signal processing unit 503 may determine, based on input power of the to-be-amplified radio frequency signal, the quantity of electron beams emitted by the electron gun in the travelling-wave tube 502 and the currents of the N electron beams, and perform encoding processing on information corresponding to the quantity of electron beams emitted by the electron gun in the travelling-wave tube 502 and the currents of the N electron beams, to form the corresponding control signal.

Optionally, the power amplification system 500 further includes a signal decomposition unit 504 and a signal calibration unit 505. The signal calibration unit 505 may implement non-linear compensation for an I-channel baseband signal (that is, an in-phase component of a baseband signal) or a Q-channel baseband signal (that is, a quadrature component of the baseband signal). The signal decomposition unit 504 may decompose the I-channel baseband signal or the Q-channel baseband signal to form a baseband amplitude signal and a baseband phase signal.

Correspondingly, the first signal processing unit 501 may perform at least one processing operation of frequency conversion, amplification, or filtering on the baseband phase signal to obtain the to-be-amplified radio frequency signal, and input the to-be-amplified radio frequency signal to the travelling-wave tube 502. In a possible implementation, the first signal processing unit 501 further has an analog-to-digital conversion function, and may perform digital-to-analog conversion on the baseband phase signal. In another possible implementation, the first signal processing unit 501 may include a digital-to-analog converter (digital-to-analog converter, DAC) and an intermediate-frequency signal processing unit. The DAC may perform digital-to-analog conversion on the baseband phase signal, and then the intermediate-frequency signal processing unit performs at least one processing operation of frequency conversion, amplification, or filtering on a baseband phase signal obtained through the analog-to-digital conversion, to obtain the to-be-amplified radio frequency signal.

Correspondingly, the second signal processing unit 503 may perform non-linear encoding on the baseband amplitude signal to form the control signal, and input the control signal to the travelling-wave tube 502. The control signal may indicate the quantity and the currents of the electron beams emitted by the travelling-wave tube 502.

Optionally, the power amplification system 500 may further include a power supply 506, and the power supply 506 may be configured to provide an operating voltage for the travelling-wave tube 502.

The foregoing describes the power amplification system provided in embodiments of this application, and the following describes a travelling-wave tube provided in embodiments of this application.

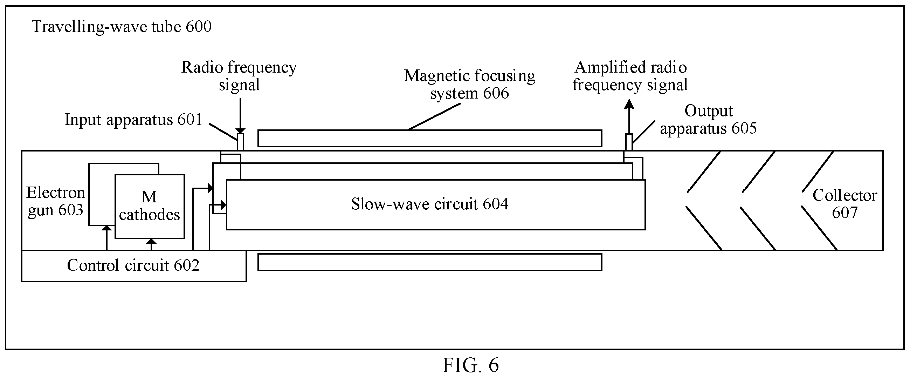

Based on the foregoing content, FIG. 6 is a diagram of a structure of a travelling-wave tube according to an embodiment of this application. In FIG. 6, an example in which the travelling-wave tube 502 is a travelling-wave tube 600 is used. The travelling-wave tube 600 includes an input apparatus 601, a control circuit 602, an electron gun 603, a slow-wave circuit 604, and an output apparatus 605. The input apparatus 601 is connected to the slow-wave circuit 604, and then after receiving a radio frequency signal, the input apparatus 601 feeds the radio frequency signal to the slow-wave circuit 604. The control circuit 602 may be configured to determine a quantity N of electron beams and currents of the N electron beams, so that electronic efficiency of the travelling-wave tube 600 is greater than or equal to a first threshold, where N is a positive integer greater than or equal to 1. The control circuit 602 is connected to the electron gun 603, so that the control circuit 602 may control the electron gun 603 to emit the N electron beams. The slow-wave circuit 604 may perform beam-wave interaction with the N electron beams, to amplify power of the radio frequency signal. The output apparatus 605 may be configured to output an amplified radio frequency signal.

In the embodiment shown in FIG. 6, the control circuit 602 determines the quantity N of electron beams emitted by the electron gun 603 in the travelling-wave tube 600 and the currents of the N electron beams, so that the control circuit 602 may control the electron gun in the travelling-wave tube 600 to emit the N electron beams. The N electron beams perform beam-wave interaction with the slow-wave circuit 604, so that input power and output power of the radio frequency signal in the travelling-wave tube 600 are linearly correlated, and the power of the radio frequency signal is linearly amplified. In addition, the slow-wave circuit 604 works in a saturation region, so that the electronic efficiency of the travelling-wave tube 600 can be greater than or equal to the first threshold. In this way, the travelling-wave tube 600 implements linear amplification on the radio frequency signal, and the electronic efficiency of the travelling-wave tube 600 is effectively improved, so that power consumption of the travelling-wave tube 600 is effectively reduced, and a low power consumption requirement of a high-frequency communication system can further be met.

Further, as shown in FIG. 6, the travelling-wave tube 600 may further include a magnetic focusing system 606. The magnetic focusing system 606 may be configured to focus the N electron beams, to enable the N electron beams to remain in a focused state. The N electron beams can further pass through the slow-wave circuit 604, and perform beam-wave interaction with the slow-wave circuit 604, to implement the linear amplification on the radio frequency signal.

Further, as shown in FIG. 6, the travelling-wave tube 600 may further include a collector 607. After the N electron beams perform beam-wave interaction with the slow-wave circuit 604, the collector 607 may recover remaining energy of the N electron beams. In this way, the power consumption of the travelling-wave tube 600 can be reduced, which helps meet the low power consumption requirement of the high-frequency communication system.

The following separately describes each structure in the travelling-wave tube 600 in detail, to provide an example of a specific implementation solution.

### 1. Input apparatus 601

In this embodiment of this application, the input apparatus 601 may be any apparatus having an energy transmission function, and the input apparatus 601 may feed a to-be-amplified radio frequency signal into the slow-wave circuit 604. In a possible implementation, the input apparatus 601 may be an input energy transmission window.

### 2. Control circuit 602

In this embodiment of this application, the control circuit 602 may be any chip or integrated circuit having a computing capability. In a possible implementation, the control circuit 602 may be a general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor, or may be any conventional processor. This is not specifically limited in this embodiment of this application.

### 3. Electron gun 603

In this embodiment of this application, the electron gun 603 may generate an electron beam having a preset size and a preset current. The electron beam may exchange energy with an electromagnetic wave travelling in the slow-wave circuit 604, to amplify the power of the radio frequency signal in the travelling-wave tube 600.

In an optional implementation, the electron gun 603 may include any one of a parallel flow Pierce electron gun, a convergent Pierce electron gun, an electron gun with a high diversion coefficient, an anode-controlled electron gun, a gate-controlled electron gun, or a focusing electrode-controlled electron gun. The anode-controlled electron gun adjusts a current of a cathode in the electron gun 603 by controlling an anode voltage, to modulate the electron beam emitted by the electron gun 603. The gate-controlled electron gun adjusts the current of the cathode in the electron gun 603 by controlling a gate voltage, to modulate the electron beam emitted by the electron gun 603. The focusing electrode-controlled electron gun adjusts the current of the cathode in the electron gun 603 by controlling a focusing electrode voltage, to modulate the electron beam emitted by the electron gun 603.

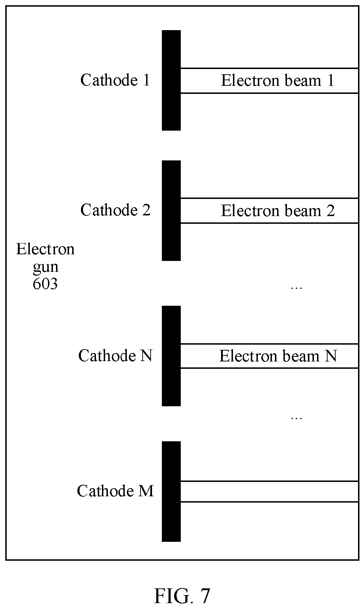

FIG. 7 is a possible diagram of a structure of an electron gun 603 according to an embodiment of this application. In FIG. 7, the electron gun 603 includes M cathodes, and the M cathodes are connected to a control circuit 602, so that the control circuit 602 may control the M cathodes. In a possible implementation, after the control circuit 602 determines a quantity N of electron beams emitted by the electron gun 603 and currents of the N electron beams, the control circuit 602 may adjust currents of the M cathodes based on the quantity N of the electron beams and the currents of the N electron beams, and control N cathodes in the M cathodes to emit the N electron beams. Each of the N cathodes may emit one of the N electron beams, a current of each of the N cathodes is related to a current of an electron beam emitted by the cathode, and the current of each of the N cathodes is greater than 0. For example, a cathode 1 is configured to emit an electron beam 1, a cathode 2 is configured to emit an electron beam 2, ..., and a cathode N is configured to emit an electron beam N.

In this embodiment of this application, "a current of each of the N cathodes is related to a current of an electron beam emitted by the cathode" may be understood as that a current of each of the N cathodes is equal to a current of an electron beam emitted by the cathode. It should be understood that when the current of the cathode in the electron gun 603 is greater than 0, the cathode can start to emit the electron beam. Therefore, the current of each of the N cathodes is greater than 0. When the current of the cathode in the electron gun 603 is 0, the cathode does not emit the electron beam. Therefore, a current of a cathode other than the N cathodes in the M cathodes is 0.

In this embodiment of this application, M is greater than or equal to N. To be specific, a quantity of cathodes in the electron gun 603 that are configured to emit the electron beams may be all or a part of cathodes in the electron gun 603.

Example 1: For example, M is 10, N is 3, and currents of three electron beams are all 6A. In this case, the control circuit 602 may adjust currents of 10 cathodes based on the currents of the three electron beams, control currents of any three cathodes in the 10 cathodes to be 6A, and control currents of the other seven cathodes in the 10 cathodes to be 0, so that only three cathodes in the 10 cathodes emit three electron beams, and each of the three cathodes emits one electron beam.

Example 2: For example, M is 10, N is 3, and currents of three electron beams are respectively 6A, 4A, and 2A. In this case, the control circuit 602 adjusts currents of 10 cathodes based on the currents of the three electron beams, so that currents of any three cathodes in the 10 cathodes are respectively 6A, 4A, and 2A. In addition, the control circuit 602 controls currents of the other seven cathodes in the 10 cathodes to be 0, so that only three cathodes in the 10 cathodes emit electron beams, and each of the three cathodes emits one electron beam.

In this embodiment of this application, the electron gun 603 may further include another component. In other words, the electron gun 603 has a plurality of implementation structures. Correspondingly, there may be also a plurality of corresponding implementations in which the control circuit 602 adjusts the currents of the M cathodes.

Implementation 1: The electron gun 603 may further include H anodes, each of the M cathodes corresponds to at least one of the H anodes, and the at least one anode is connected to the control circuit 602. Correspondingly, a corresponding implementation in which the control circuit 602 adjusts the currents of the M cathodes may be as follows: The control circuit 602 may adjust the currents of the M cathodes by adjusting a voltage of the at least one anode.

In this embodiment of this application, H is greater than or equal to M. Optionally, H may be an integer multiple of M. To be specific, a quantity of anodes in the electron gun 603 may be an integer multiple of a quantity of cathodes in the electron gun 603.

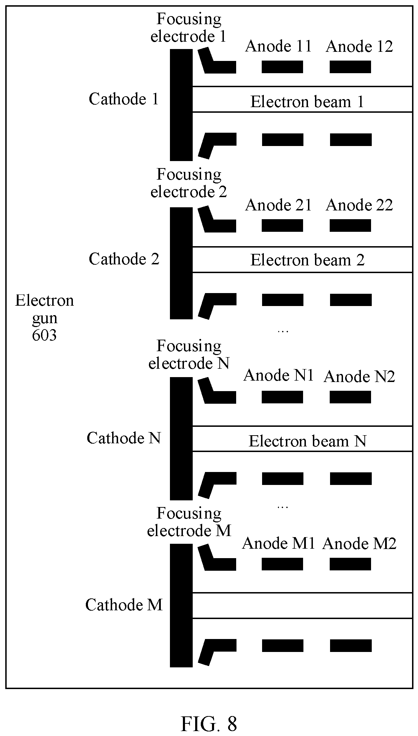

Example 1: As shown in FIG. 8, the quantity of anodes in the electron gun 603 is twice the quantity of cathodes in the electron gun 603. A cathode 1 corresponds to an anode 11 and an anode 12, a cathode 2 corresponds to an anode 21 and an anode 22, ..., a cathode N corresponds to an anode N1 and an anode N2, and a cathode M corresponds to an anode M1 and an anode M2. In addition, the anode 11, the anode 21, ..., and the anode M1 are connected to the control circuit 602, so that the control circuit 602 may adjust the currents of the M cathodes by adjusting voltages of the anode 11, the anode 21, ..., and the anode M1.

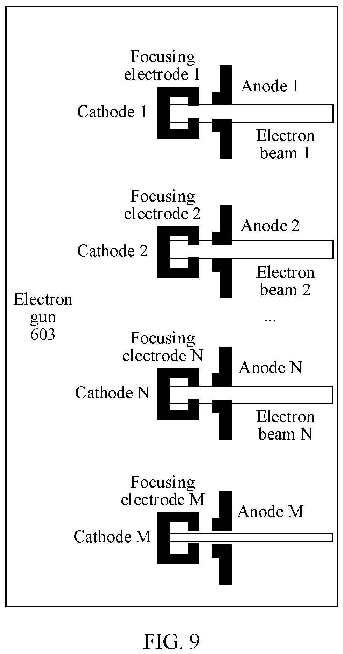

Example 2: As shown in FIG. 9, the quantity of anodes in the electron gun 603 is one time the quantity of cathodes in the electron gun 603. In other words, the quantity of anodes in the electron gun 603 is the same as the quantity of cathodes in the electron gun 603. A cathode 1 corresponds to an anode 1, a cathode 2 corresponds to an anode 2, ..., a cathode N corresponds to an anode N, and a cathode M corresponds to an anode M. In addition, the anode 1, the anode 2, ..., and the anode M are connected to the control circuit 602, so that the control circuit 602 may adjust the currents of the M cathodes by adjusting voltages of the anode 1, the anode 2, ..., and the anode M.

Implementation 2: As shown in FIG. 8 or FIG. 9, the electron gun 603 may further include M focusing electrodes, and each of the M focusing electrodes is in one-to-one correspondence with each of the M cathodes. A cathode 1 corresponds to a focusing electrode 1, a cathode 2 corresponds to a focusing electrode 2, ..., a cathode N corresponds to an anode N, and a cathode M corresponds to an anode M. The M focusing electrodes are connected to the control circuit 602, so that the control circuit 602 may adjust the currents of the M cathodes by adjusting voltages of the M focusing electrodes.

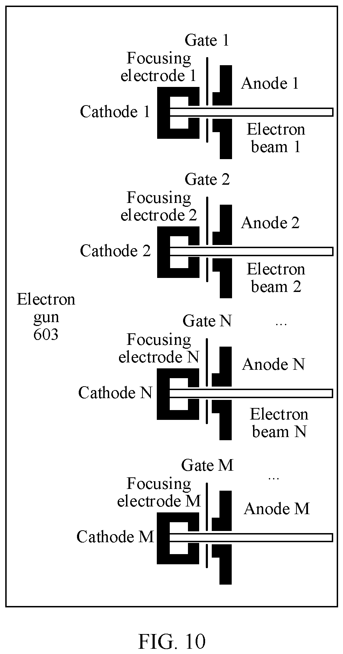

Implementation 3: As shown in FIG. 10, the electron gun 603 may further include M gates, and each of the M gates is in one-to-one correspondence with each of the M cathodes. A cathode 1 corresponds to a gate 1, a cathode 2 corresponds to a gate 2, ..., a cathode N corresponds to an anode N, and a cathode M corresponds to an anode M. The M gates are connected to the control circuit 602, so that the control circuit 602 may adjust the currents of the M cathodes by adjusting voltages of the M gates.

### 4. Slow-wave circuit 604

In this embodiment of this application, the slow-wave circuit 604 may be any circuit having a signal amplification function. In a possible implementation, the slow-wave circuit 604 may be a spiral line circuit or a coupled cavity circuit. The spiral line slow-wave circuit may include any one of a spiral line, an annular rod line, or an annular circle line, and the coupled cavity slow-wave circuit includes a Hughes circuit or a three-leaf clover circuit. This is not specifically limited in this embodiment of this application.

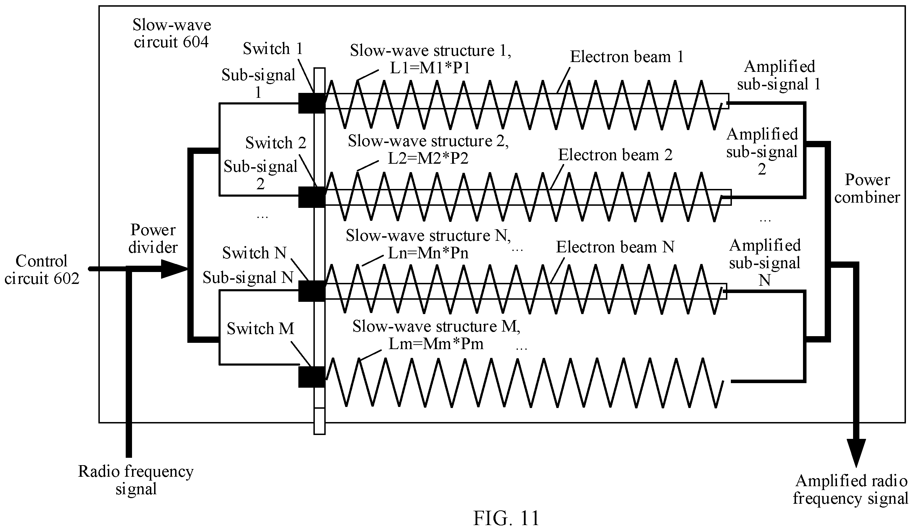

As shown in FIG. 11, the slow-wave circuit 604 includes a power divider, M slow-wave structures, M switches, and a power combiner. The power divider, the M switches, and the power combiner are separately connected to the control circuit 602, so that the control circuit 602 may control the power divider to decompose the radio frequency signal fed into the slow-wave circuit 604 into N sub-signals, and the control circuit 602 may control N switches in the M switches to be turned on, and input the N sub-signals to N slow-wave structures in the M slow-wave structures, where the N switches are in one-to-one correspondence with the N slow-wave structures, and one of the N sub-signals is input to one of the N slow-wave structures.

In this embodiment of this application, M is greater than or equal to N. To be specific, a slow-wave structure to which the sub-signal is input in the slow-wave circuit 604 may be all or a part of the slow-wave structures in the slow-wave circuit 604.

It should be understood that the foregoing M slow-wave structures are in one-to-one correspondence with the M switches. To be specific, a slow-wave structure 1 corresponds to a switch 1, a slow-wave structure 2 corresponds to a switch 2, ..., a slow-wave structure N corresponds to a switch N, and a slow-wave structure M corresponds to a switch M. One switch may be configured to control whether the radio frequency signal is input to a slow-wave structure corresponding to the switch. If the switch is turned on, the radio frequency signal may be input to the slow-wave structure corresponding to the switch; or if the switch is turned off, the radio frequency signal is not input to the slow-wave structure corresponding to the switch. For example, the switch 1 may control whether the radio frequency signal is input to the slow-wave structure 1, the switch 2 may control whether the radio frequency signal is input to the slow-wave structure 2, ..., the switch N may control whether the radio frequency signal is input to the slow-wave structure N, and the switch M may control whether the radio frequency signal is input to the slow-wave structure M.

In a possible implementation, after the N sub-signals are input to the N slow-wave structures in the M slow-wave structures, N electron beams passing through the N slow-wave structures perform beam-wave interaction with the N slow-wave structures, to amplify power of the N sub-signals, where one of the N electron beams performs beam-wave interaction with one of the N slow-wave structures through which the electron beam passes, to amplify power of one sub-signal input to the one slow-wave structure. Further, the control circuit 602 may control the power combiner to combine amplified N sub-signals into the amplified radio frequency signal.

For example, still refer to FIG. 11. The control circuit 602 may control the power divider to decompose the radio frequency signal into a sub-signal 1, a sub-signal 2, ..., and a sub-signal N. The control circuit 602 may turn on the switch 1, the switch 2, ..., and the switch N, and input the sub-signal 1 to the slow-wave structure 1, the sub-signal 2 to the slow-wave structure 2, ..., and the sub-signal N to the slow-wave structure N. Further, the electron beam 1 passes through the slow-wave structure 1, and the electron beam 1 performs beam-wave interaction with the slow-wave structure 1 to amplify power of the sub-signal 1; further, the electron beam 2 passes through the slow-wave structure 2, and the electron beam 2 performs beam-wave interaction with the slow-wave structure 2 to amplify power of the sub-signal 2; ...; and the electron beam N passes through the slow-wave structure N, and the electron beam N performs beam-wave interaction with the slow-wave structure N to amplify power of the sub-signal N. Further, the control circuit 602 may control the power combiner to combine an amplified sub-signal 1, an amplified sub-signal 2, ..., and an amplified sub-signal N into the amplified radio frequency signal.

It should be noted that lengths of the slow-wave structure 1, the slow-wave structure 2, ..., the slow-wave structure N, and the slow-wave structure M may be the same or different. A length of each slow-wave structure is designed based on a preset gain (that is, an amplification multiple) of the slow-wave structure. For example, a larger preset gain of the slow-wave structure N indicates a larger length of the slow-wave structure N. Optionally, when the slow-wave structure N is a spiral line circuit, the length of the slow-wave structure N is Ln=Mn*Pn, where Mn is a quantity of periodicities of the spiral line circuit included in the slow-wave structure N, and Pn is a periodicity length corresponding to each spiral line circuit. As shown in FIG. 11, a length of the slow-wave structure 1 is L1=M1*P1, a length of the slow-wave structure 2 is L2=M2*P2, ..., the length of the slow-wave structure N is Ln=Mn*Pn, and a length of the slow-wave structure M is Lm=Mm*Pm.

It should be further noted that, in this embodiment of this application, that the control circuit 602 controls the power divider to decompose the radio frequency signal fed into the slow-wave circuit 604 into the N sub-signals includes but is not limited to the following implementations.

Implementation 1: The control circuit 602 receives a control signal, where the control signal indicates a value of the quantity N of electron beams emitted by the electron gun 603 and the currents of the N electron beams. Because the quantity N of electron beams is the same as a quantity N of sub-signals, the control circuit 602 may control, based on the control signal, the power divider to decompose the radio frequency signal in the slow-wave circuit 604 into the N sub-signals.

For example, if the control signal received by the control circuit 602 indicates that the value of the quantity N of electron beams emitted by the electron gun 603 is 4, the control circuit 602 controls the power divider to decompose the radio frequency signal in the slow-wave circuit 604 into four sub-signals.

Implementation 2: The control circuit 602 may control, based on the input power of the radio frequency signal in the slow-wave circuit 604, the power divider to decompose the radio frequency signal into the N sub-signals.

Example 1: If the input power of the to-be-amplified radio frequency signal in the travelling-wave tube 600 is less than or equal to a second threshold, the control circuit 602 does not need to decompose the radio frequency signal, and directly inputs the radio frequency signal into the slow-wave structure 1 in the slow-wave circuit 604.

Example 2: If the input power of the to-be-amplified radio frequency signal in the travelling-wave tube 600 is greater than a second threshold, the control circuit 602 may control the power divider to decompose the to-be-amplified radio frequency signal in the travelling-wave tube 600 into the sub-signal 1 and the sub-signal 2. The sub-signal 1 is input to the slow-wave structure 1 in the slow-wave circuit 604, and the sub-signal 2 is input to the slow-wave structure 2 in the slow-wave circuit 604.

### 5. Output apparatus 605

In this embodiment of this application, the output apparatus 605 may be any apparatus having an energy transmission function. In a possible implementation, the input apparatus 601 may be an output energy transmission window, configured to output the amplified radio frequency signal.

### 6. Magnetic focusing system 606

In this embodiment of this application, the magnetic focusing system 606 may be any apparatus having an electron beam focusing function, and may be configured to focus the electron beam emitted by the electron gun 603, so that the electron beam passes through the slow-wave circuit 604.

### 7. Collector 607

In this embodiment of this application, the collector 607 may be any apparatus having an energy recovery function. In a possible implementation, the collector 607 may be a single-stage voltage reduction collection apparatus or a multi-stage voltage reduction collection apparatus.

It should be noted that, when the control circuit 602 determines the quantity N of electron beams emitted by the electron gun 603 and the currents of the N electron beams, there are a plurality of implementations, including but not limited to the following implementations.

Implementation 1: The control circuit 602 receives the control signal, where the control signal indicates the value of N and the currents of the N electron beams, so that the control circuit 602 may determine, based on the control signal, the quantity N of electron beams emitted by the electron gun 603 and the currents of the N electron beams. In this way, the control circuit 602 directly determines the quantity N of electron beams and the currents of the N electron beams based on the received control signal, and implementation of the control circuit 602 is simple, and is easy to be implemented by the travelling-wave tube 600.

For example, the control circuit 602 may receive a control signal from the second signal processing unit 503 (as shown in FIG. 5), and determine, based on the control signal, the quantity N of electron beams emitted by the electron gun and the currents of the N electron beams.

In this embodiment of this application, the control signal has a plurality of implementation cases, including but not limited to the following cases.

Case 1: Coding information corresponding to the control signal includes a control bit and a digital bit, where the control bit indicates the quantity N of electron beams emitted by the electron gun 603, and the digital bit indicates the currents of the N electron beams.

For example, if the quantity N of electron beams is 3, and currents of the three electron beams are all 6A, the control bit in the control signal may be "0011", to be specific, the control bit indicates that the quantity N of electron beams emitted by the electron gun 603 is 3; and the digital bit in the control signal may be "0110", to be specific, the digital bit indicates that the current of each electron beam is 6A.

For another example, if the quantity N of electron beams is 4, and currents of the four electron beams are respectively 6A, 4A, 2A, and 1A, the control bit in the control signal may be "0100", where the control bit indicates that the quantity N of electron beams emitted by the electron gun 603 is 4; and the digital bit in the control signal may be "0110 0100 0010 0001", to be specific, the digital bit indicates that the currents of the four electron beams are respectively 6A, 4A, 2A, and 1A.

Case 2: Coding information corresponding to the control signal includes a control bit and a digital bit, where the control bit indicates a quantity N of cathodes in the electron gun 603 that are configured to emit the electron beams, and the digital bit indicates the currents of the N electron beams. It should be understood that, in Case 2, one cathode in the electron gun 603 is configured to emit one electron beam. Therefore, the quantity N of cathodes in the electron gun 603 that are configured to emit the electron beams is the same as the quantity N of electron beams emitted by the electron gun 603.

For example, if the electron gun 603 includes four cathodes, only two cathodes in the four cathodes are configured to emit electron beams, and currents of the electron beams emitted by the two cathodes are both 2A, the control bit in the control signal may be "0011", to be specific, the control bit indicates that the electron gun 603 includes four cathodes, only two cathodes in the four cathodes emit electron beams, a cathode corresponding to a control bit " 1" in the four cathodes emits the electron beam, and a cathode corresponding to a control bit "0" in the four cathodes does not emit the electron beam; and the digital bit in the control signal may be "0010", to be specific, the digital bit indicates that the currents of the electron beams emitted by the two cathodes are both 2A.

For another example, if the electron gun 603 includes four cathodes, only two cathodes in the four cathodes are configured to emit electron beams, and currents of the electron beams emitted by the two cathodes are respectively 2A and 1A, the control bit in the control signal may be "0011", to be specific, the control bit indicates that the electron gun 603 includes four cathodes, and only two cathodes in the four cathodes emit electron beams, to be specific, a cathode corresponding to a control bit" 1" in the four cathodes emits the electron beam, and a cathode corresponding to a control bit "0" in the four cathodes does not emit the electron beam; and the digital bit in the control signal may be "0010 0001", to be specific, the digital bit indicates that the currents of the electron beams emitted by the two cathodes are respectively 2A and 1A.

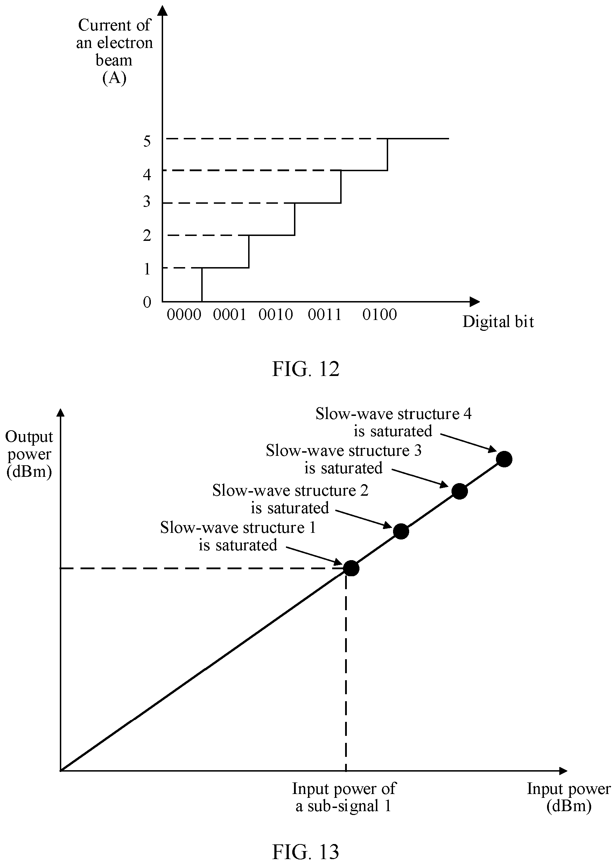

Further, for ease of understanding, FIG. 12 shows a mapping relationship between the current of the electron beam and the digital bit. As shown in FIG. 12, when the current of the electron beam is 0, the digital bit in the control signal is 0000; when the current of the electron beam is 1A, the digital bit in the control signal is 0001; when the current of the electron beam is 2A, the digital bit in the control signal is 0010; when the current of the electron beam is 3A, the digital bit in the control signal is 0011; or when the current of the electron beam is 4A, the digital bit in the control signal is 0100.

Implementation 2: The control circuit 602 may determine the value of N and the currents of the N electron beams based on the input power of the radio frequency signal. In this way, the control circuit 602 does not need to receive the control signal, and directly determines the value of N and the currents of the N electron beams based on the input power of the radio frequency signal, to effectively improve efficiency of determining the quantity N of electron beams and the currents of the N electron beams by the control circuit 602.

In a possible implementation, the control circuit 602 may determine the output power of the radio frequency signal based on the input power of the radio frequency signal and a preset gain of the travelling-wave tube 600, and the control circuit 602 may further determine the value of N and the currents of the N electron beams based on the output power of the radio frequency signal and target electronic efficiency of the travelling-wave tube. The "preset gain" may be understood as a direct ratio of the output power of the radio frequency signal to the input power of the radio frequency signal, or may be referred to as a preset amplification multiple of the travelling-wave tube 600. Therefore, the output power of the radio frequency signal=the input power of the radio frequency signal *the preset gain. The "target electronic efficiency" may be understood as an electronic efficiency threshold that needs to be met in a process in which the travelling-wave tube 600 performs linear amplification on the power of the radio frequency signal. The target electronic efficiency is the foregoing first threshold, and a value of the first threshold may be, for example, any one of 70%, 80%, or 90%. This is not limited in this embodiment of this application.

It can be learned from the foregoing descriptions that the slow-wave circuit 604 includes a plurality of slow-wave structures. Electronic efficiency of each slow-wave structure in the plurality of slow-wave structures working in the saturation region is target electronic efficiency of the slow-wave structure. In addition, in this embodiment of this application, the target electronic efficiency of each slow-wave structure and the target electronic efficiency of the travelling-wave tube 600 are the same, and may both be the first threshold, and a preset gain of each slow-wave structure may be the same as or different from the preset gain of the travelling-wave tube 600.

In addition, it can be learned from the foregoing descriptions that the control circuit 602 may control the power divider to decompose the to-be-amplified radio frequency signal in the travelling-wave tube 600 into the sub-signal 1, the sub-signal 2, ..., and the sub-signal N, one sub-signal is input to one slow-wave structure, and one of the N electron beams emitted by the electron gun 603 may pass through one slow-wave structure. Therefore, in a possible implementation, target electronic efficiency of the slow-wave structure N=output power of the sub-signal N in the slow-wave structure N/(a voltage of the electron beam N in the slow-wave structure N*a current of the electron beam N). The voltage of the electron beam N is a constant voltage value provided by a power supply of the travelling-wave tube 600, and the output power of the sub-signal N=input power of the sub-signal N*a preset gain of the slow-wave structure N. In this case, the current of the electron beam N=(the input power of the sub-signal N*the preset gain of the slow-wave structure N)/(the voltage of the electron beam N in the slow-wave structure N*target electronic efficiency of the slow-wave structure N). In this way, when the preset gain of the slow-wave structure N, the target electronic efficiency of the slow-wave structure N, and the voltage of the electron beam N in the slow-wave structure N are learned, the control circuit 602 may determine an appropriate current of the electron beam N, so that the slow-wave structure N can work in the saturation region, and electronic efficiency of the slow-wave structure N is greater than or equal to the target electronic efficiency, to improve overall electronic efficiency of the travelling-wave tube 600.

The following describes cases in which the control circuit 602 determines the value of N and the currents of the N electron beams based on the input power of the radio frequency signal.

Case 1: If the input power of the to-be-amplified radio frequency signal in the travelling-wave tube 600 is less than or equal to the second threshold, the control circuit 602 determines that the value of N is 1, and determines the currents of the N electron beams.

It should be noted that the "second threshold" may be understood as saturation input power of the slow-wave structure 1 (to be specific, input power corresponding to the slow-wave structure 1 working at a saturation point). Therefore, when the input power of the to-be-amplified radio frequency signal in the travelling-wave tube 600 is less than or equal to the second threshold, the electron gun 603 needs to emit only one electron beam, and the electron beam passes through the slow-wave structure 1. A current of the electron beam is adjusted, so that the slow-wave structure 1 can work in the saturation region, and electronic efficiency of the slow-wave structure 1 is improved, to further effectively improve the overall electronic efficiency of the travelling-wave tube 600.

For example, the target electronic efficiency of the travelling-wave tube 600 is the first threshold, target electronic efficiency of the slow-wave structure 1 in the travelling-wave tube 600 is the first threshold, and the second threshold is 100 dBm. If the input power of the to-be-amplified radio frequency signal in the travelling-wave tube 600 is 90 dBm, the input power of the radio frequency signal is less than the second threshold. Correspondingly, the quantity of electron beams emitted by the electron gun 603 is 1, and the electron beam passes through the slow-wave structure 1. In this case, a current of the electron beam=(the input power of the radio frequency signal*a preset gain of the slow-wave structure 1)/(a voltage of the electron beam 1*the first threshold).

Case 2: If the input power of the to-be-amplified radio frequency signal in the travelling-wave tube 600 is greater than the second threshold, the control circuit 602 determines that the value of N is greater than 1, and determines the currents of the N electron beams, where a current of at least one of the N electron beams reaches a current threshold of the at least one electron beam, and the value of N is positively correlated with the input power of the radio frequency signal.

It can be learned from the foregoing descriptions that the control circuit 602 may control the power divider to decompose the to-be-amplified radio frequency signal in the travelling-wave tube 600 into the sub-signal 1, the sub-signal 2, ..., and the sub-signal N, and one sub-signal is input to one slow-wave structure. In this embodiment of this application, " a current threshold of at least one of the N electron beams that can be reached by a current of the at least one electron beam" may be understood as a current corresponding to each of the at least one electron beam when a slow-wave structure through which the electron beam passes works in the saturation region. For example, when the electron beam 1 passes through the slow-wave structure 1, the sub-signal 1 passes through the slow-wave structure 1, and the slow-wave structure 1 works in the saturation region, a current of the electron beam 1=(input power of the sub-signal 1*the preset gain of the slow-wave structure N)/(a voltage of the electron beam 1*target electronic efficiency of the slow-wave structure 1). In addition, "the value of N is positively correlated with the input power of the radio frequency signal" may be understood as that larger input power of the radio frequency signal indicates a larger value of N.

Example 1: The target electronic efficiency of the travelling-wave tube 600 is the first threshold, target electronic efficiency of the slow-wave structure 1 and target electronic efficiency of the slow-wave structure 2 in the travelling-wave tube 600 are the first threshold, the saturation input power of the slow-wave structure 1 is the second threshold, and saturation input power of the slow-wave structure 2 is a third threshold. If the input power of the to-be-amplified radio frequency signal in the travelling-wave tube 600 is greater than the second threshold, and the input power of the radio frequency signal is less than a sum value between the second threshold and the third threshold, the control circuit 602 needs to control the power divider to decompose the radio frequency signal into the sub-signal 1 and the sub-signal 2, and correspondingly, the electron gun 603 needs to emit two electron beams. In addition, the current of the electron beam 1 reaches a current threshold of the electron beam 1. To be specific, the current of the electron beam 1 = (the input power of the sub-signal 1*the preset gain of the slow-wave structure 1)/(the voltage of the electron beam 1*the first threshold). A current of the electron beam 2 does not reach a current threshold of the electron beam 2. In this case, the current of the electron beam 2=(the input power of the radio frequency signal*the preset gain-the saturation output power of the slow-wave structure 1)/(a voltage of the electron beam 2*the first threshold).

Example 2: The target electronic efficiency of the travelling-wave tube 600 is the first threshold, target electronic efficiency of the slow-wave structure 1, target electronic efficiency of the slow-wave structure 2, and target electronic efficiency of the slow-wave structure 3 in the travelling-wave tube 600 are the first threshold, the saturation input power of the slow-wave structure 1 is the second threshold, saturation input power of the slow-wave structure 2 is a third threshold, and saturation input power of the slow-wave structure 3 is a fourth threshold. If the input power of the to-be-amplified radio frequency signal in the travelling-wave tube 600 is greater than a sum value between the second threshold and the third threshold, and the input power of the radio frequency signal is less than a sum value between the second threshold, the third threshold, and the fourth threshold, the control circuit 602 needs to control the power divider to decompose the radio frequency signal into the sub-signal 1, the sub-signal 2, and the sub-signal 3, and correspondingly, the electron gun 603 needs to emit three electron beams. In addition, the current of the electron beam 1 reaches a current threshold of the electron beam 1. To be specific, the current of the electron beam 1=(the input power of the sub-signal 1*the preset gain of the slow-wave structure 1)/(the voltage of the electron beam 1*the first threshold). A current of the electron beam 2 reaches a current threshold of the electron beam 2. To be specific, the current of the electron beam 2=(input power of the sub-signal 2*a preset gain of the slow-wave structure 2)/(a voltage of the electron beam 2*the first threshold). If a current of the electron beam 3 does not reach a current threshold of the electron beam 3, the current of the electron beam 3=(the input power of the radio frequency signal *the preset gain-the saturation output power of the slow-wave structure 1-the saturation output power of the slow-wave structure 2)/(a voltage of the electron beam 3*the first threshold).

In Case 2, the second threshold, the third threshold, and the fourth threshold may be set to different values, that is, the saturation input power of the slow-wave structure 1, the saturation input power of the slow-wave structure 2, and the saturation input power of the slow-wave structure 3 are different, and the control circuit 602 further controls the power divider to decompose the to-be-amplified radio frequency signal in the travelling-wave tube 600, so that input power of the obtained sub-signal 1, sub-signal 2, and sub-signal 3 may be different. Therefore, in a possible implementation, the control circuit 602 controls the power divider to perform gradient decomposition on the to-be-amplified radio frequency signal in the travelling-wave tube 600. That is, input power of the sub-signal 1, input power of the sub-signal 2, ..., and input power of the sub-signal N that are obtained through decomposition change in a gradient manner. For example, the input power of the sub-signal 1 may be 100 dBm, the input power of the sub-signal 2 may be 80 dBm, and the input power of the sub-signal 3 may be 60 dBm. In this way, the slow-wave structure can be flexibly designed, to implement refined control on the slow-wave structure.

Case 3: If the input power of the to-be-amplified radio frequency signal in the travelling-wave tube 600 is greater than the second threshold, the control circuit 602 determines that the value of N is greater than 1, and determines the currents of the N electron beams, where the currents of all of the N electron beams are equal, and the value of N is positively correlated with the input power of the radio frequency signal.

Example 1: The target electronic efficiency of the travelling-wave tube 600 is the first threshold, target electronic efficiency of the slow-wave structure 1 and target electronic efficiency of the slow-wave structure 2 in the travelling-wave tube 600 are the first threshold, and saturation input power of the slow-wave structure 1 and saturation input power of the slow-wave structure 2 are both the second threshold. If the input power of the to-be-amplified radio frequency signal in the travelling-wave tube 600 is greater than the second threshold, and the input power of the radio frequency signal is less than twice the second threshold, if the input power of the to-be-amplified radio frequency signal in the travelling-wave tube 600 is greater than the second threshold, the control circuit 602 needs to control the power divider to decompose the radio frequency signal into the sub-signal 1 and the sub-signal 2, and correspondingly, the electron gun 603 needs to emit two electron beams. In addition, input power of the sub-signal 1 and input power of the sub-signal 2 are equal. In this case, a current of the electron beam 1=a current of the electron beam 2=(the input power of the sub-signal 1*the preset gain of the slow-wave structure 1)/(a voltage of the electron beam 1*the first threshold).

Example 2: The target electronic efficiency of the travelling-wave tube 600 is the first threshold, target electronic efficiency of the slow-wave structure 1 and target electronic efficiency of the slow-wave structure 2 in the travelling-wave tube 600 are the first threshold, and saturation input power of the slow-wave structure 1, saturation input power of the slow-wave structure 2, and saturation input power of the slow-wave structure 3 are all the second threshold. If the input power of the to-be-amplified radio frequency signal in the travelling-wave tube 600 is greater than twice the second threshold, and the input power of the radio frequency signal is less than three times the second threshold, the control circuit 602 needs to control the power divider to decompose the radio frequency signal into the sub-signal 1, the sub-signal 2, and the sub-signal 3, and correspondingly, the electron gun 603 needs to emit three electron beams. In addition, input power of the sub-signal 1, input power of the sub-signal 2, and input power of the sub-signal 3 are equal. In this case, a current of the electron beam 1=a current of the electron beam 2=a current of the electron beam 3=(the input power of the sub-signal 1*the preset gain of the slow-wave structure 1)/(a voltage of the electron beam 1*the first threshold).

In Case 3, the saturation input power of the slow-wave structure 1, the saturation input power of the slow-wave structure 2, and the saturation input power of the slow-wave structure 3 are set to be the same, and the control circuit 602 further controls the power divider to decompose the to-be-amplified radio frequency signal in the travelling-wave tube 600, so that the input power of the obtained sub-signal 1, sub-signal 2, and sub-signal 3 may be the same. Therefore, in a possible implementation, the control circuit 602 controls the power divider to equally decompose the to-be-amplified radio frequency signal in the travelling-wave tube 600. That is, input power of the sub-signal 1, input power of the sub-signal 2, ..., and input power of the sub-signal N that are obtained through decomposition are all the same. For example, the input power of the sub-signal 1, the sub-signal 2, and the sub-signal 3 may be 80 dBm. In this way, control logic of the control circuit 602 can be simple and easy to implement.

For ease of understanding, the following describes, with reference to the power amplification system in FIG. 5, an entire process in which a travelling-wave tube 600 amplifies power of a radio frequency signal in embodiments of this application.

### Embodiment 1

The process in which the travelling-wave tube 600 amplifies the power of the radio frequency signal includes the following steps.

S101: An input apparatus 601 receives a radio frequency signal from a first signal processing unit 501, and feeds the radio frequency signal into a slow-wave circuit 604.

S102: A control circuit 602 receives a control signal from a second signal processing unit 503, where the control signal indicates a value of N and currents of N electron beams; and the control circuit 602 determines a quantity N of electron beams and the currents of the N electron beams based on the control signal, where N is a positive integer greater than or equal to 1.

It should be understood that, for specific implementation of the control signal, refer to the foregoing related descriptions. Details are not described herein again.

S103: The control circuit 602 adjusts currents of M cathodes in an electron gun based on the value of N and the currents of the N electron beams, to control N cathodes in the M cathodes to emit the N electron beams.

S104: The control circuit 602 controls, based on the value of N, a power divider to decompose the radio frequency signal fed into the slow-wave circuit 604 into N sub-signals, and controls N switches in the slow-wave circuit 604 to be turned on, so that the N sub-signals are input to N slow-wave structures in the slow-wave circuit 604.

S105: The N electron beams pass through the N slow-wave structures, and perform beam-wave interaction with the N slow-wave structures, to amplify the N sub-signals, where one of the N electron beams performs beam-wave interaction with one of the N slow-wave structures through which the electron beam passes, to amplify power of a sub-signal input to the slow-wave structure.

S106: The control circuit 602 controls, based on the value of N, a power combiner to combine N amplified sub-signals, to obtain an amplified radio frequency signal.

S107: An output apparatus 605 outputs the amplified radio frequency signal.

In Embodiment 1, the control circuit 602 controls, based on the received control signal, the electron gun to emit the N electron beams, controls the currents of the N electron beams, and controls the N switches in the slow-wave circuit 604 to be turned on, so that the N sub-signals are input to the N slow-wave structures in the slow-wave circuit 604, and the N electron beams passing through the N slow-wave structures perform beam-wave interaction with the N slow-wave structures, to amplify the N sub-signals. In this way, linear amplification on the slow-wave circuit 604 is implemented, the N slow-wave structures can work in a saturation region, and electronic efficiency of the N slow-wave structures are effectively improved, so that electronic efficiency of the travelling-wave tube 600 is effectively improved, and the electronic efficiency of the travelling-wave tube 600 can be greater than or equal to a first threshold (namely, target electronic efficiency).

As shown in FIG. 13, for example, N is 4, and a slow-wave structure 1, a slow-wave structure 2, a slow-wave structure 3, and a slow-wave structure 4 all work in the saturation region, so that input power and output power of sub-signals input to the slow-wave structure 1, the slow-wave structure 2, the slow-wave structure 3, and the slow-wave structure 4 are all linearly correlated, and linear amplification on the sub-signals input to the slow-wave structure 1, the slow-wave structure 2, the slow-wave structure 3, and the slow-wave structure 4 is implemented.

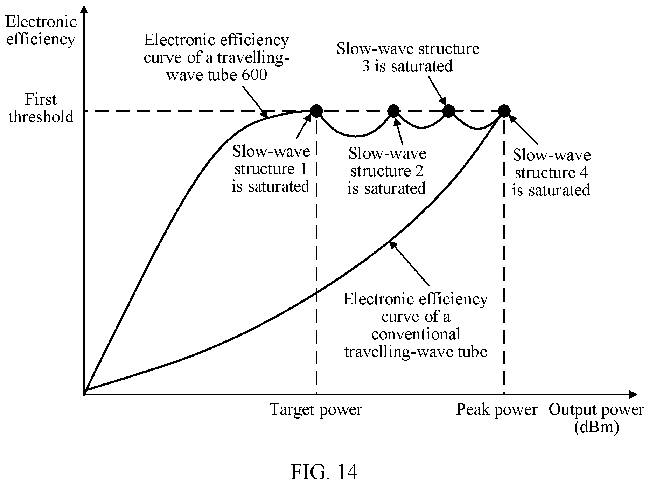

As shown in FIG. 14, when a slow-wave structure 1, a slow-wave structure 2, a slow-wave structure 3, and a slow-wave structure 4 all work in the saturation region, electronic efficiency of the slow-wave structure 1, electronic efficiency of the slow-wave structure 2, electronic efficiency of the slow-wave structure 3, and electronic efficiency of the slow-wave structure 4 are equal to the first threshold, so that total electronic efficiency of the travelling-wave tube 600 is equal to the first threshold. In comparison with a conventional travelling-wave tube, the electronic efficiency of the travelling-wave tube 600 provided in this embodiment of this application is effectively improved, so that a low power consumption requirement of a high-frequency communication system can be met.

It can be learned from the foregoing descriptions that the travelling-wave tube 600 includes the slow-wave circuit 604, the slow-wave circuit 604 includes a plurality of slow-wave structures, and electronic efficiency of each slow-wave structure is related to input power of a radio frequency signal input to the slow-wave structure.

For example, a radio frequency signal 1 is input to the slow-wave structure 1, and an electron beam 1 passes through the slow-wave structure 1. If input power of the radio frequency signal 1 is less than saturation input power of the slow-wave structure 1 (that is, radio frequency input power corresponding to the slow-wave structure 1 working at a saturation point), the electronic efficiency of the slow-wave structure 1=(the input power of the radio frequency signal 1*an amplification multiple)/(a voltage of the electron beam 1*a current of the electron beam 1).

For another example, a radio frequency signal 1 is input to the slow-wave structure 1, an electron beam 1 passes through the slow-wave structure 1, a radio frequency signal 2 is input to the slow-wave structure 2, and an electron beam 2 passes through the slow-wave structure 2. If input power of the radio frequency signal 1 is greater than or equal to saturation input power of the slow-wave structure 1 (that is, input power corresponding to the slow-wave structure 1 working at a saturation point), and input power of the radio frequency signal 2 is less than saturation input power of the slow-wave structure 2 (that is, input power corresponding to the slow-wave structure 2 working at a saturation point), the electronic efficiency of the slow-wave structure 1 is preset target electronic efficiency (that is, the first threshold), and the electronic efficiency of the slow-wave structure 2=(total output power of the travelling-wave tube-the saturation output power of the slow-wave structure 1)/(a voltage of the electron beam 2*(a current of the electron beam 1+a current of the electron beam 2)). In this way, when the total output power of the travelling-wave tube 600 remains unchanged, the slow-wave structure 2 can work in the saturation region by adjusting currents of the electron beam 1 and the electron beam 2, so that the electronic efficiency of the slow-wave structure 2 remains at the target electronic efficiency.

For another example, a radio frequency signal 1 is input to the slow-wave structure 1, and an electron beam 1 passes through the slow-wave structure 1; a radio frequency signal 2 is input to the slow-wave structure 2, and an electron beam 2 passes through the slow-wave structure 2; and a radio frequency signal 3 is input to the slow-wave structure 3, and an electron beam 3 passes through the slow-wave structure 3. If input power of the radio frequency signal 1 is greater than or equal to saturation input power of the slow-wave structure 1, input power of the radio frequency signal 2 is greater than or equal to saturation input power of the slow-wave structure 2, and input power of the radio frequency signal 3 is less than saturation input power of the slow-wave structure 3, the electronic efficiency of the slow-wave structure 1 and the electronic efficiency of the slow-wave structure 2 are both preset target electronic efficiency (that is, the first threshold), and the electronic efficiency of the slow-wave structure 3=(total output power of the travelling-wave tube-the saturation output power of the slow-wave structure 1-the saturation output power of the slow-wave structure 2)/(a voltage of the electron beam 3*(a current of the electron beam 1+a current of the electron beam 2+a current of the electron beam 3)). In this way, when the total output power of the travelling-wave tube 600 remains unchanged, the slow-wave structure 2 and the slow-wave structure 3 can work in the saturation region by adjusting currents of the electron beam 1, the electron beam 2, and the electron beam 3, so that the electronic efficiency of the slow-wave structure 2 and the electronic efficiency of the slow-wave structure 3 remain at the target electronic efficiency.

By analogy, a radio frequency signal 1 is input to the slow-wave structure 1, and an electron beam 1 passes through the slow-wave structure 1; a radio frequency signal 2 is input to the slow-wave structure 2, and an electron beam 2 passes through the slow-wave structure 2; a radio frequency signal 3 is input to the slow-wave structure 3, and an electron beam 3 passes through the slow-wave structure 3; ...; and a radio frequency signal N is input to a slow-wave structure N, and an electron beam N passes through the slow-wave structure N. If input power of the radio frequency signal 1 is greater than or equal to saturation input power of the slow-wave structure 1, input power of the radio frequency signal 2 is greater than or equal to saturation input power of the slow-wave structure 2, input power of the radio frequency signal 3 is greater than or equal to saturation input power of the slow-wave structure 3, ..., and input power of the radio frequency signal N is greater than or equal to saturation input power of the slow-wave structure N, the electronic efficiency of the slow-wave structure 1, the electronic efficiency of the slow-wave structure 2, the electronic efficiency of the slow-wave structure 3, ..., and electronic efficiency of the slow-wave structure N are all preset target electronic efficiency (that is, the first threshold).

### Embodiment 2

The process in which the travelling-wave tube 600 amplifies the power of the radio frequency signal includes the following steps.

S201: An input apparatus 601 receives a radio frequency signal from a first signal processing unit 501, and feeds the radio frequency signal into a slow-wave circuit 604.

S202: A control circuit 602 determines a quantity N of electron beams and currents of the N electron beams based on input power of the radio frequency signal, where N is a positive integer greater than or equal to 1.

It should be understood that, for a specific implementation in which the control circuit 602 may determine a value of N and the currents of the N electron beams based on the input power of the radio frequency signal, refer to the foregoing descriptions. Details are not described herein again.

S203: The control circuit 602 adjusts currents of M cathodes in an electron gun based on the value of N and the currents of the N electron beams, to control N cathodes in the M cathodes to emit the N electron beams.

S204: The control circuit 602 controls, based on the value of N, a power divider to decompose the radio frequency signal fed into the slow-wave circuit 604 into N sub-signals, and controls N switches in the slow-wave circuit 604 to be turned on, so that the N sub-signals are input to N slow-wave structures in the slow-wave circuit 604.

S205: The N electron beams pass through the N slow-wave structures, and perform beam-wave interaction with the N slow-wave structures, to amplify the N sub-signals, where one of the N electron beams performs beam-wave interaction with one of the N slow-wave structures through which the electron beam passes, to amplify power of a sub-signal input to the slow-wave structure.

S206: The control circuit 602 controls, based on the value of N, a power combiner to combine N amplified sub-signals, to obtain an amplified radio frequency signal.

S207: An output apparatus 605 outputs the amplified radio frequency signal.

In Embodiment 2, the control circuit 602 may dynamically adjust, based on the input power of the radio frequency signal, the quantity of electron beams emitted by the electron gun 603 and the currents of electron beams, and control the N switches in the slow-wave circuit 604 to be turned on, so that the N sub-signals are input to the N slow-wave structures in the slow-wave circuit 604, and the N electron beams passing through the N slow-wave structures perform beam-wave interaction with the N slow-wave structures, to amplify the N sub-signals. In this way, linear amplification on the slow-wave circuit 604 is implemented, the N slow-wave structures can work in a saturation region, and electronic efficiency of the N slow-wave structures are effectively improved, so that electronic efficiency of the travelling-wave tube 600 is effectively improved, and the electronic efficiency of the travelling-wave tube 600 can be greater than or equal to a first threshold (namely, target electronic efficiency).

In some possible implementations, a gain (that is, an amplification multiple) of each slow-wave structure in the slow-wave circuit 604 may be adjusted. It can be learned from the foregoing descriptions that, when input power of a sub-signal N in a slow-wave structure N is greater than saturation input power of the slow-wave structure N (that is, input power corresponding to the slow-wave structure N working at a saturation point), target electronic efficiency of the slow-wave structure N=(the input power of the sub-signal N in the slow-wave structure N*a gain of the slow-wave structure N)/(a voltage of the electron beam N in the slow-wave structure N*a current of the electron beam N passing through the slow-wave structure N).

Correspondingly, the gain of the slow-wave structure N=(the target electronic efficiency of the slow-wave structure N*(the voltage of the electron beam N passing through the slow-wave structure N*the current of the electron beam N))/the input power of the sub-signal N in the slow-wave structure N. Therefore, when the slow-wave structure N is saturated, to be specific, electronic efficiency of the slow-wave structure N is equal to the target electronic efficiency (that is, the first threshold), the control circuit 602 may increase the gain of the slow-wave structure N by continuously increasing the current of the electron beam N, so that amplification performance of the slow-wave structure N is effectively improved, and amplification performance of the travelling-wave tube is further effectively improved.

For example, when input power of a sub-signal 1 input to a slow-wave structure 1 is less than saturation input power of the slow-wave structure 1 (that is, input power corresponding to the slow-wave structure 1 working at a saturation point), a gain of the slow-wave structure 1=(target electronic efficiency of the slow-wave structure 1*(a voltage of an electron beam 1 passing through the slow-wave structure 1*a current of the electron beam 1))/input power of the sub-signal 1. The control circuit 602 may increase the gain of the slow-wave structure 1 by increasing the current of the electron beam 1.

Based on a same technical concept, an embodiment of this application further provides an electron gun. The electron gun includes M cathodes and a control circuit. The control circuit may be configured to determine a quantity N of electron beams and currents of the N electron beams. Electronic efficiency of a travelling-wave tube is greater than or equal to a first threshold, N is a positive integer greater than or equal to 1, and M is greater than or equal to N. N cathodes in the M cathodes may be configured to emit N electron beams under control of the control circuit, where each of the N cathodes is configured to emit one of the N electron beams.

In this embodiment of this application, the control circuit is added to the electron gun. The control circuit may control the quantity and the currents of the electron beams emitted by the electron gun. Further, when the electron beams emitted by the electron gun are used to amplify a radio frequency signal of the travelling-wave tube, electronic efficiency of the travelling-wave tube is greater than or equal to a first threshold, to meet a low power consumption requirement of the travelling-wave tube.

In a possible design, that the control circuit is configured to determine the quantity N of electron beams and the currents of the N electron beams includes: receiving a control signal, where the control signal indicates a value of N and the currents of the N electron beams; or determining a value of N and the currents of the N electron beams based on input power of a to-be-amplified radio frequency signal in the travelling-wave tube.

In a possible design, that the control circuit is configured to determine the value of N and the currents of the N electron beams based on the input power of the radio frequency signal includes: if the input power of the radio frequency signal is less than or equal to a second threshold, determining that the value of N is 1, and determining the currents of the N electron beams; or if the input power of the radio frequency signal is greater than a second threshold, determining that the value of N is greater than 1, and determining the currents of the N electron beams, where a current of at least one of the N electron beams reaches a current threshold of the at least one electron beam, and the value of N is positively correlated with the input power of the radio frequency signal.

In a possible design, that the control circuit controls the N cathodes in the M cathodes to emit the N electron beams includes: adjusting currents of the M cathodes based on the value of N and the currents of the N electron beams, to control a current of each of the N cathodes to be greater than 0, where the current of each of the N cathodes is related to a current of an electron beam emitted by the cathode.

In a possible design, the electron gun further includes H anodes, where each of the M cathodes corresponds to at least one of the H anodes, the at least one anode is connected to the control circuit, and H is greater than or equal to M. That the control circuit adjusts the currents of the M cathodes includes: adjusting a voltage of the at least one anode.

In a possible design, the electron gun further includes M gates, where the M gates are connected to the control circuit, and the M cathodes are in one-to-one correspondence with the M gates. That the control circuit adjusts the currents of the M cathodes includes: adjusting voltages of the M gates.

In a possible design, the electron gun further includes M focusing electrodes, where the M focusing electrodes are connected to the control circuit, and the M cathodes are in one-to-one correspondence with the M focusing electrodes. That the control circuit adjusts the currents of the M cathodes includes: adjusting voltages of the M focusing electrodes.

For specific details, refer to the foregoing detailed descriptions of the electron gun 603 in the travelling-wave tube 600. Details are not described herein again.

A person skilled in the art should understand that embodiments of this application may be provided as a method, a system, or a computer program product. Therefore, this application may use a form of hardware-only embodiments, software-only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to this application. It should be understood that computer program instructions may be used to implement each procedure and/or block in the flowcharts and/or block diagrams and a combination of procedures and/or blocks in the flowcharts and/or block diagrams. These computer program instructions may be provided for a general-purpose computer, a dedicated computer, an embedded processor, or a processor of another programmable data processing device to generate a machine, so that the instructions executed by a computer or a processor of another programmable data processing device generate an apparatus for implementing a specific function in one or more procedures in the flowcharts and/or one or more blocks in the block diagrams.

These computer program instructions may alternatively be stored in a computer-readable memory that can indicate a computer or another programmable data processing device to work in a specific manner, so that the instructions stored in the computer-readable memory generate an artifact that includes an instruction apparatus. The instruction apparatus implements a specific function in one or more procedures in the flowcharts and/or one or more blocks in the block diagrams.

These computer program instructions may alternatively be loaded onto a computer or another programmable data processing device, so that a series of operation steps are performed on the computer or the another programmable device, to generate computer-implemented processing. Therefore, the instructions executed on the computer or the another programmable device provide steps for implementing a specific function in one or more procedures in the flowcharts and/or one or more blocks in the block diagrams.

It is clear that a person skilled in the art can make various modifications and variations to this application without departing from the spirit and scope of this application. In this way, this application is intended to cover these modifications and variations of this application provided that they fall within the scope of the claims of this application and equivalent technologies thereof.

## Claims

1. A travelling-wave tube, comprising an input apparatus, a control circuit, an electron gun, a slow-wave circuit, and an output apparatus, wherein
the input apparatus is configured to: receive a radio frequency signal, and feed the radio frequency signal into the slow-wave circuit; and the control circuit is configured to determine a quantity N of electron beams and currents of the N electron beams, wherein electronic efficiency of the travelling-wave tube is greater than or equal to a first threshold, and N is a positive integer greater than or equal to 1;
the electron gun is configured to emit the N electron beams under control of the control circuit;
the slow-wave circuit is configured to perform beam-wave interaction with the N electron beams, to amplify power of the radio frequency signal; and
the output apparatus is configured to output an amplified radio frequency signal.

2. The travelling-wave tube according to claim 1, wherein the slow-wave circuit comprises a power divider, M slow-wave structures, and M switches, wherein the M slow-wave structures are in one-to-one correspondence with the M switches, and M is greater than or equal to N; and
the control circuit is further configured to:
control the power divider to decompose the radio frequency signal fed into the slow-wave circuit into N sub-signals; and
turn on N switches in the M switches, and input the N sub-signals to N slow-wave structures in the M slow-wave structures, wherein the N switches are in one-to-one correspondence with the N slow-wave structures, and one of the N sub-signals is input to one of the N slow-wave structures.

3. The travelling-wave tube according to claim 2, wherein that the slow-wave circuit performs beam-wave interaction with the N electron beams, to amplify the power of the radio frequency signal comprises:
the N electron beams passing through the N slow-wave structures perform beam-wave interaction with the N slow-wave structures, to amplify power of the N sub-signals, wherein
one of the N electron beams performs beam-wave interaction with one of the N slow-wave structures through which the electron beam passes, to amplify power of one sub-signal input to the one slow-wave structure.

4. The travelling-wave tube according to claim 2 or 3, wherein the slow-wave circuit further comprises a power combiner; and
the control circuit is further configured to:
control the power combiner to combine amplified N sub-signals into the amplified radio frequency signal.

5. The travelling-wave tube according to any one of claims 1 to 4, wherein that the control circuit is configured to determine the quantity N of electron beams and the currents of the N electron beams comprises:
receiving a control signal, wherein the control signal indicates a value of N and the currents of the N electron beams; or
determining a value of N and the currents of the N electron beams based on input power of the radio frequency signal.

6. The travelling-wave tube according to claim 5, wherein that the control circuit determines the value of N and the currents of the N electron beams based on the input power of the radio frequency signal comprises:
if the input power of the radio frequency signal is less than or equal to a second threshold, determining that the value of N is 1, and determining the currents of the N electron beams; or
if the input power of the radio frequency signal is greater than a second threshold, determining that the value of N is greater than 1, and determining the currents of the N electron beams, wherein a current of at least one of the N electron beams reaches a current threshold of the at least one electron beam, and the value of N is positively correlated with the input power of the radio frequency signal.

7. The travelling-wave tube according to any one of claims 1 to 6, wherein the electron gun comprises M cathodes, wherein M is greater than or equal to N; and
that the control circuit controls the electron gun to emit the N electron beams comprises:
adjusting currents of the M cathodes based on the value of N and the currents of the N electron beams, and controlling N cathodes in the M cathodes to emit the N electron beams, wherein each of the N cathodes is configured to emit one of the N electron beams, a current of each of the N cathodes is related to a current of an electron beam emitted by the cathode, and the current of each of the N cathodes is greater than 0.

8. The travelling-wave tube according to claim 7, wherein the electron gun further comprises H anodes, wherein each of the M cathodes corresponds to at least one of the H anodes, the at least one anode is connected to the control circuit, and H is greater than or equal to M; and
that the control circuit adjusts the currents of the M cathodes comprises:
adjusting a voltage of the at least one anode.

9. The travelling-wave tube according to claim 7, wherein the electron gun further comprises M gates, wherein the M cathodes are in one-to-one correspondence with the M gates, and the M gates are connected to the control circuit; and
that the control circuit adjusts the currents of the M cathodes comprises:
adjusting voltages of the M gates.

10. The travelling-wave tube according to claim 7, wherein the electron gun further comprises M focusing electrodes, wherein the M cathodes are in one-to-one correspondence with the M focusing electrodes, and the M focusing electrodes are connected to the control circuit; and
that the control circuit adjusts the currents of the M cathodes comprises:
adjusting voltages of the M focusing electrodes.

11. The travelling-wave tube according to any one of claims 1 to 10, further comprising a magnetic focusing system, wherein
the magnetic focusing system is configured to focus the N electron beams, to enable the N electron beams to remain in a focused state.

12. An electron gun, comprising M cathodes and a control circuit, wherein the control circuit is configured to determine a quantity N of electron beams and currents of the N electron beams, electronic efficiency of a travelling-wave tube is greater than or equal to a first threshold, N is a positive integer greater than or equal to 1, and M is greater than or equal to N; and
N cathodes in the M cathodes are configured to emit the N electron beams under control of the control circuit, wherein each of the N cathodes is configured to emit one of the N electron beams.

13. The electron gun according to claim 12, wherein that the control circuit is configured to determine the quantity N of electron beams and the currents of the N electron beams comprises:
receiving a control signal, wherein the control signal indicates a value of N and the currents of the N electron beams; or
determining a value of N and the currents of the N electron beams based on input power of a to-be-amplified radio frequency signal in the travelling-wave tube.

14. The electron gun according to claim 13, wherein that the control circuit is configured to determine the value of N and the currents of the N electron beams based on the input power of the radio frequency signal comprises:
if the input power of the radio frequency signal is less than or equal to a second threshold, determining that the value of N is 1, and determining the currents of the N electron beams; or
if the input power of the radio frequency signal is greater than a second threshold, determining that the value of N is greater than 1, and determining the currents of the N electron beams, wherein a current of at least one of the N electron beams reaches a current threshold of the at least one electron beam, and the value of N is positively correlated with the input power of the radio frequency signal.

15. The electron gun according to any one of claims 12 to 14, wherein that the control circuit controls the N cathodes in the M cathodes to emit the N electron beams comprises:
adjusting currents of the M cathodes based on the value of N and the currents of the N electron beams, to control a current of each of the N cathodes to be greater than 0, wherein
the current of each of the N cathodes is related to a current of an electron beam emitted by the cathode.

16. The electron gun according to claim 15, wherein the electron gun further comprises H anodes, wherein each of the M cathodes corresponds to at least one of the H anodes, the at least one anode is connected to the control circuit, and H is greater than or equal to M; and
that the control circuit adjusts the currents of the M cathodes comprises:
adjusting a voltage of the at least one anode.

17. The electron gun according to claim 15, wherein the electron gun further comprises M gates, wherein the M cathodes are in one-to-one correspondence with the M gates, and the M gates are connected to the control circuit; and
that the control circuit adjusts the currents of the M cathodes comprises:
adjusting voltages of the M gates.

18. The electron gun according to claim 15, wherein the electron gun further comprises M focusing electrodes, wherein the M cathodes are in one-to-one correspondence with the M focusing electrodes, and the M focusing electrodes are connected to the control circuit; and
that the control circuit adjusts the currents of the M cathodes comprises:
adjusting voltages of the M focusing electrodes.

19. A power amplification system, comprising a first signal processing unit and the travelling-wave tube according to any one of claims 1 to 11, wherein the first signal processing unit is connected to the travelling-wave tube;
the first signal processing unit is configured to input a radio frequency signal to the travelling-wave tube; and
the travelling-wave tube is configured to amplify power of the radio frequency signal.

20. The system according to claim 19, further comprising a second signal processing unit, wherein
the second signal processing unit is configured to: generate a control signal, and input the control signal to the travelling-wave tube, wherein
the control signal indicates a quantity of electron beams emitted by an electron gun in the travelling-wave tube and currents of the N electron beams.
